# EUROPEAN PATENT APPLICATION

(11) **EP 4 679 226 A1**
(43) Date of publication of application: **14.01.2026**
(21) Application number: 25184387.6
(22) Date of filing: 23.06.2025
(51) Int. Cl.: G06F 1/16, H04M 1/02

(54) **SUPPORT PLATE HAVING PLATE LATTICE, DISPLAY DEVICE INCLUDING THE SAME, AND MANUFACTURING METHOD THEREOF**

(30) Priority: 11.07.2024 KR 20240091799; 21.03.2025 KR 20250036839
(71) Applicant: Samsung Display Co., Ltd., Yongin-si, Gyeonggi-do (KR)
(72) Inventor: EO, Sungwoo, Yongin-si, Gyeonggi-Do (KR); LEE, Yonghyuck, Yongin-si, Gyeonggi-Do (KR)
(74) Representative: Gulde & Partner

(57) **Abstract**

Disclosed is a display device which includes a display module including a non-folding area and a folding area arranged in a first direction and a support plate including a folding part that overlaps the folding area. An opening extending in a second direction crossing the first direction is defined in the folding part, and the opening includes a first opening defined in a lower surface of the folding part and a second opening defined above the first opening. In the second direction, a first length of the first opening and a second length of the second opening are different from each other.

## Description

### BACKGROUND

Embodiments of the present disclosure described herein relate to a display device and a method of manufacturing the display device.

Electronic devices, such as smart phones, digital cameras, notebook computers, car navigation units, smart televisions, and the like, which provide an image to a user may include a display device for displaying an image. The display device generates an image and provides the image to the user through a display screen.

With the development of display device technology, various types of display devices are being developed. For example, various flexible display devices capable of being curved, folded, or rolled are being developed. Flexible display devices capable of being deformed in various ways are easy to carry and improve user convenience.

Among the flexible display devices, a foldable display device may be foldable about a folding axis extending in one direction. The foldable display device includes a folding area that is bendable in a folding operation and a non-folding area that is flat. The folding area may be bent to have a certain radius of curvature.

Since the folding area has flexible characteristics, the folding area may be easily deformed and damaged by external impact. Accordingly, a display device capable of improving the impact resistance of the folding area is desired.

### SUMMARY

Embodiments of the present disclosure provide a display device including a folding area with improved impact resistance and a method of manufacturing the display device.

According to an embodiment, a display device includes a display module including a non-folding area and a folding area arranged in a first direction and a support plate including a folding part that overlaps the folding area. An opening extending in a second direction crossing the first direction is defined in the folding part, and the opening includes a first opening defined in a lower surface of the folding part and a second opening defined above the first opening. In the second direction, a first length of the first opening and a second length of the second opening are different from each other.

According to an embodiment, a display device includes a display module including a non-folding area and a folding area arranged in a first direction and a support plate including a folding part that overlaps the folding area. An opening extending in a second direction crossing the first direction is defined in the folding part, and the opening includes a first opening defined in a lower surface of the folding part and a second opening defined in an upper surface of the folding part. In the second direction, a first length of the first opening and a second length of the second opening are different from each other, and in a direction perpendicular to a plane defined by the first direction and the second direction, a first depth of the first opening and a second depth of the second opening are different from each other.

According to an embodiment, a display device includes a display module including a non-folding area and a folding area arranged in a first direction and a support plate including a folding part that overlaps the folding area. An opening extending in a second direction crossing the first direction is defined in the folding part, and the opening includes a first opening defined in a lower surface of the folding part and a second opening defined in an upper surface of the folding part. A first width of the first opening in the first direction is greater than a second width of the second opening in the first direction. Each of the first width and the second width gradually decreases in a direction from a bottom to a top of the display device. A reduction rate of the first width is varied, and a reduction rate of the second width is constant.

According to an embodiment, an electronic device includes a display device including a display module and an electronic module that controls operation of the display module. The display device includes the display module including a non-folding area and a folding area arranged in a first direction and a support plate including a folding part that overlaps the folding area. An opening that extends in a second direction crossing the first direction is defined in the folding part. The opening includes a first opening defined in a lower surface of the folding part and a second opening defined above the first opening. In the second direction, a first length of the first opening and a second length of the second opening are different from each other.

According to an embodiment, a support plate includes a folding part and a non-folding part adjacent to the folding part. An opening that extends in a second direction crossing a first direction is defined in the folding part. The opening includes a first opening defined in a lower surface of the folding part and a second opening defined above the first opening. In the second direction, a first length of the first opening and a second length of the second opening are different from each other.

According to an embodiment, a method for manufacturing a support plate includes a step of preparing a support plate and a photoresist disposed on a lower surface of the support plate and having an opening defined therein to overlap a folding part of the support plate, a step of defining a first opening in a lower surface of the folding part by supplying an etching solution to the lower surface of the folding part through the opening of the photoresist, and a step of defining a second opening that penetrates an upper surface of the folding part, by applying a laser beam toward the first opening from below the folding part. In a second direction, a first length of the first opening and a second length of the second opening are different from each other, and in a direction perpendicular to a plane defined by a first direction and the second direction, a first depth of the first opening and a second depth of the second opening are different from each other.

### BRIEF DESCRIPTION OF THE DRAWINGS

The above and other objects and features of the present disclosure will become apparent by describing in detail embodiments thereof with reference to the accompanying drawings.
FIG. 1 is a perspective view of a display device according to an embodiment of the present disclosure.
FIG. 2 is a view illustrating a folded state of the display device illustrated in FIG. 1.
FIG. 3 is a plan view of a display panel used in the display device illustrated in FIG. 1.
FIG. 4 is a sectional view of the display panel illustrated in FIG. 3.
FIG. 5 is a view illustrating a cross-section of the display panel corresponding to one pixel in FIG. 4.
FIG. 6 is a sectional view of the display device corresponding to line I-I' illustrated in FIG. 3.
FIG. 7 is a sectional view taken along line II-II' illustrated in FIG. 3.
FIG. 8 is a sectional view taken along line III-III' illustrated in FIG. 3, where FIG. 8 illustrates a state in which a bending area is bent.
FIG. 9 is a view illustrating a folded state of the display device illustrated in FIG. 6.
FIG. 10 is a perspective view of a first support plate illustrated in FIG. 6.
FIG. 11 is an enlarged view of area AA illustrated in FIG. 10 when the first support plate illustrated in FIG. 10 is viewed from below.
FIG. 12 is an enlarged view of area AA illustrated in FIG. 10 when the first support plate illustrated in FIG. 10 is viewed from above.
FIG. 13 is a sectional view taken along line IV-IV' illustrated in FIG. 12.
FIG. 14A is an enlarged view of one of openings illustrated in FIG. 13.
FIG. 14B is a view illustrating a structure in which the first depth and the second depth are set differently from the first depth and the second depth as illustrated in FIG. 14A.
FIG. 15 is a sectional view taken along line V-V' illustrated in FIG. 12.
FIG. 16 is a view illustrating the first support plate in which the openings illustrated in FIGS. 13 to 15 are defined and a display module attached to the first support plate.
FIG. 17 is a view illustrating a first comparative support plate PLT1' according to a comparative example.
FIG. 18 is a view illustrating a ball drop test result for the display device of the present disclosure and a comparative display device including the first comparative support plate illustrated in FIG. 17.
FIG. 19 is a view illustrating an artificial nail press test result for the display device of the present disclosure and the comparative display device including the first comparative support plate illustrated in FIG. 17.
FIG. 20 is a graph depicting results of a ball drop test and an artificial nail press test performed on a comparative display device while varying the widths of the openings illustrated in FIG. 17.
FIG. 21 is a table illustrating results of a ball drop test and an artificial nail press test performed on the display device while varying the ratio between first openings and second openings of the first support plate of the present disclosure.
FIGS. 22A to 22D are views illustrating a manufacturing method of the display device according to an embodiment of the present disclosure.
FIG. 23 is a view illustrating a configuration of a display device according to an embodiment of the present disclosure.
FIGS. 24 to 28 are views illustrating configurations of first support plates according to various embodiments of the present disclosure.
FIG. 29 is a view illustrating a configuration of a first support plate according to an embodiment of the present disclosure.
FIG. 30 is a view illustrating a configuration of an opening according to an embodiment of the present disclosure.
FIG. 31 is a sectional view taken along line VI-VI' illustrated in FIG. 30.
FIGS. 32 and 33 are views illustrating configurations of openings according to embodiments of the present disclosure.
FIG. 34 is a view illustrating a configuration of a first support plate according to an embodiment of the present disclosure.
FIG. 35 is an exploded perspective view of an electronic device including the display module and a support part according to an embodiment of the present disclosure.
FIG. 36 is an enlarged view of one of openings illustrated in FIG. 27.
FIG. 37 is a view illustrating a ball drop test result for display devices including the support plates illustrated in FIGS. 13 and 27 and comparative display devices including the first comparative support plate illustrated in FIG. 17.
FIG. 38A is a view illustrating a configuration of a first support plate according to an embodiment of the present disclosure.
FIG. 38B is an enlarged view of one of openings illustrated in FIG. 38A.
FIG. 39 is a view illustrating a configuration of a first support plate according to an embodiment of the present disclosure.

### DETAILED DESCRIPTION

In this specification, when a component (or, an area, a layer, a part, or the like) is referred to as being "on", "connected to" or "coupled to" another component, this means that the component may be directly on, connected to, or coupled to the other component or a third component may be present therebetween.

Identical reference numerals refer to identical components. In some aspects, in the drawings, the thicknesses, proportions, and dimensions of components are exaggerated for effective description.

As used herein, the term "and/or" includes all of one or more combinations defined by related components.

Terms such as first, second, and the like may be used to describe various components, but the components should not be limited by the terms. The terms as used herein may distinguish one component from other components. For example, without departing the scope of the present disclosure, a first component may be referred to as a second component, and similarly, the second component may also be referred to as the first component. The terms of a singular form may include plural forms unless otherwise specified.

In some aspects, terms such as, for example, "below", "under", "above", and "over" are used to describe a relationship between components illustrated in the drawings. The terms are relative concepts and are described based on directions illustrated in the drawing.

The terms "about" or "approximately" as used herein are inclusive of the stated value and include a suitable range of deviation for the particular value as determined by one of ordinary skill in the art, considering the measurement in question and the error associated with measurement of the particular quantity. The terms "about" or "approximately" can mean within one or more standard deviations, or within ± 30%, 20%, 10%, 5% of the stated value, for example.

The term "substantially," as used herein, means approximately or actually. The term "substantially equal" means approximately or actually equal. The term "substantially the same" means approximately or actually the same. The term "substantially perpendicular" means approximately or actually perpendicular. The term "substantially parallel" means approximately or actually parallel.

Unless otherwise defined, all terms used herein, including technical or scientific terms, have the same meanings as those generally understood by those skilled in the art to which the present disclosure pertains. Such terms as those defined in a generally used dictionary are to be interpreted as having meanings equal to the contextual meanings in the relevant field of art, and are not to be interpreted as having ideal or excessively formal meanings unless clearly defined as having such in the present application.

It should be understood that terms such as, for example, "comprise", "include", and "have", when used herein, specify the presence of stated features, numbers, steps, operations, components, parts, or combinations thereof, but do not preclude the presence or addition of one or more other features, numbers, steps, operations, components, parts, or combinations thereof.

Hereinafter, embodiments of the present disclosure will be described with reference to the accompanying drawings.

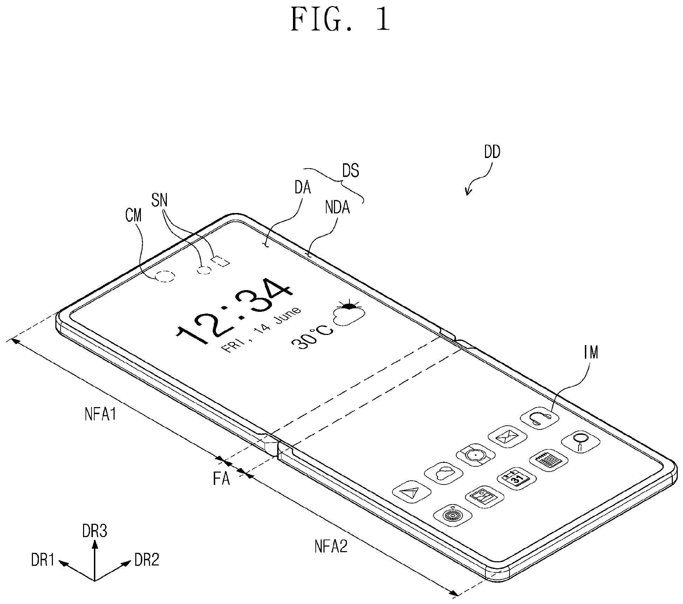

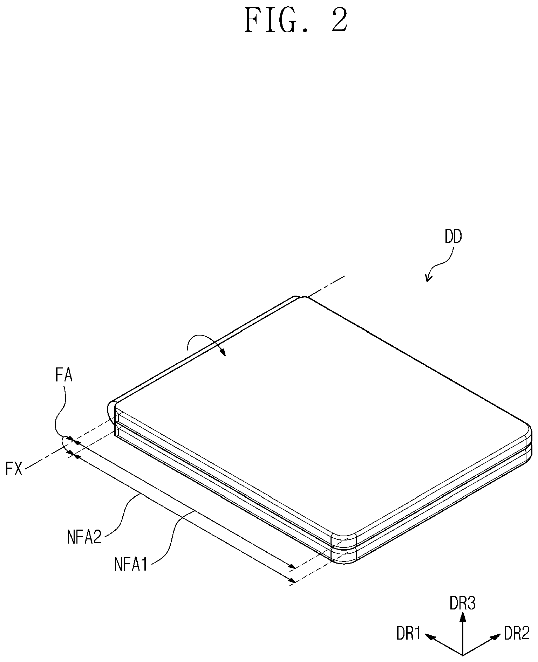

FIG. 1 is a perspective view of a display device according to an embodiment of the present disclosure. FIG. 2 is a view illustrating a folded state of the display device illustrated in FIG. 1.

Referring to FIG. 1, the display device DD according to an embodiment of the present disclosure may have a rectangular shape with long sides extending in a first direction DR1 and short sides extending in a second direction DR2 crossing the first direction DR1. However, without being limited thereto, the display device DD may have various shapes such as, for example, a circular shape, a polygonal shape, and the like. The display device DD may be a flexible display device.

Hereinafter, a direction substantially perpendicular to a plane defined by the first direction DR1 and the second direction DR2 is defined as a third direction DR3. The expression "when viewed from above the plane" used herein may mean that it is viewed in the third direction DR3. In some aspects, the meaning of "overlap" in this specification may refer to a state in which components are disposed such that the components overlap each other when viewed from above the plane.

The display device DD may include a folding area FA and a plurality of non-folding areas NFA1 and NFA2. The non-folding areas NFA1 and NFA2 may include the first non-folding area NFA1 and the second non-folding area NFA2. The folding area FA may be disposed between the first non-folding area NFA1 and the second non-folding area NFA 2. The first non-folding area NFA1, the folding area FA, and the second non-folding area NFA 2 may be arranged in the first direction DR1.

Although one folding area FA and two non-folding areas NFA 1 and NFA2 are illustrated as an example, the number of folding areas FA and the number of non-folding areas NFA1 and NFA2 are not limited thereto. For example, the display device DD may include more than two non-folding areas and a plurality of folding areas disposed between the non-folding areas.

The upper surface of the display device DD may be defined as a display surface DS and may have a plane defined by the first direction DR1 and the second direction DR2. Images IM generated by the display device DD may be provided to a user through the display surface DS.

The display surface DS may include a display area DA and a non-display area NDA around the display area DA. The display area DA may display an image, and the non-display area NDA may not display an image. The non-display area NDA may surround the display area DA and may define the border of the display device DD that is printed in a certain color.

The display device DD may include a plurality of sensors SN and at least one camera CM. The sensors SN and the camera CM may be adjacent to the border of the display device DD. The sensors SN and the camera CM may be disposed in the display area DA adjacent to the non-display area NDA. The sensors SN and the camera CM may be disposed in the first non-folding area NFA1. However, the positions of the sensors SN and the camera CM are not limited thereto.

For example, the sensors SN may be proximity illuminance sensors. However, the types of sensors SN are not limited thereto. The camera CM may take an external image.

Referring to FIG. 2, the display device DD may be a foldable display device DD that is folded or unfolded. For example, the folding area FA may be bent about a folding axis FX parallel to the second direction DR2, and the display device DD may be folded accordingly.

When the display device DD is folded, the first non-folding area NFA1 and the second non-folding area NFA 2 may face each other, and the display device DD may be folded in an in-folding manner such that the display surface DS is not exposed to the outside. However, embodiments of the present disclosure are not limited thereto. For example, the display device DD may be folded about the folding axis FX in an out-folding manner such that the display surface DS is exposed to the outside.

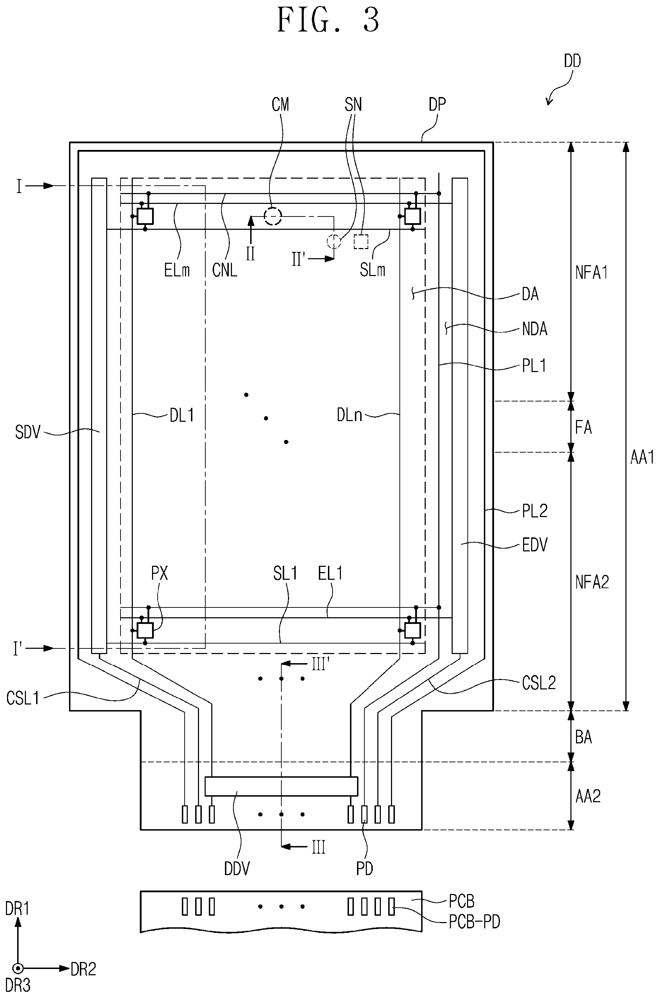

FIG. 3 is a plan view of a display panel used in the display device illustrated in FIG. 1.

Referring to FIG. 3, the display device DD may include the display panel DP, a scan driver SDV, a data driver DDV, and an emission driver EDV.

The display panel DP according to an embodiment of the present disclosure may be an emissive display panel. For example, the display panel DP may be an organic light emitting display panel or an inorganic light emitting display panel. An emissive layer of the organic light emitting display panel may include an organic luminescent material. An emissive layer of the inorganic light emitting display panel may include quantum dots, quantum rods, and the like. Hereinafter, in the examples described herein, the display panel DP is an organic light emitting display panel.

The display panel DP may be a flexible display panel. For example, the display panel DP may include a plurality of electronic elements disposed on a flexible substrate. The display panel DP may extend longer in the first direction DR1 than in the second direction DR2. The display panel DP may have a plane defined by the first direction DR1 and the second direction DR2.

The display panel DP may include a first area AA1, a second area AA2, and a bending area BA between the first area AA1 and the second area AA2. The bending area BA may extend in the second direction DR2, and the first area AA1, the bending area BA, and the second area AA2 may be arranged in the first direction DR1.

The first area AA1 may have long sides that extend in the first direction DR1 and are opposite to each other in the second direction DR2. Based on the second direction DR2, the lengths of the bending area BA and the second area AA2 may be shorter than the length of the first area AA1.

The first area AA1 may include a display area DA and a non-display area NDA around the display area DA. The non-display area NDA may surround the display area DA. The display area DA may be an area that displays an image, and the non-display area NDA may be an area that does not display an image. The second area AA2 and the bending area BA may be areas that do not display an image. The sensors SN and the camera CM may be disposed in the display area DA.

The first area AA1 may include a first non-folding area NFA1, a second non-folding area NFA2, and a folding area FA between the first non-folding area NFA1 and the second non-folding area NFA2. The first non-folding area NFA1, the folding area FA, and the second non-folding area NFA2 of the display panel DP may correspond to the first non-folding area NFA1, the folding area FA, and the second non-folding area NFA2 of the display device DD, respectively, which are illustrated FIG. 1.

The display panel DP may include a plurality of pixels PX, a plurality of scan lines SL1 to SLm, a plurality of data lines DL1 to DLn, a plurality of emission lines EL1 to ELm, a first control line CSL1, a second control line CSL2, a first power line PL1, a second power line PL2, a plurality of connecting lines CNL, and a plurality of pads PD. "m" and "n" are natural numbers. The pixels PX may be disposed in the display area DA and may be connected to the scan lines SL1 to SLm, the data lines DL1 to DLn, and the emission lines EL1 to ELm.

The scan driver SDV and the emission driver EDV may be disposed in the non-display area NDA. The scan driver SDV and the emission driver EDV may be disposed in the non-display areas NDA adjacent to the long sides of the first area AA1, respectively. The data driver DDV may be disposed in the second area AA2. The data driver DDV may be manufactured in the form of an integrated circuit chip and may be mounted on the second area AA2.

The scan lines SL1 to SLm may extend in the second direction DR2 and may be connected to the scan driver SDV. The data lines DL1 to DLn may extend in the first direction DR1 and may be connected to the data driver DDV via the bending area BA. The emission lines EL1 to ELm may extend in the second direction DR2 and may be connected to the emission driver EDV.

The first power line PL1 may extend in the first direction DR1 and may be disposed in the non-display area NDA. The first power line PL1 may be disposed between the display area DA and the emission driver EDV. However, without being limited thereto, the first power line PL1 may be disposed between the display area DA and the scan driver SDV.

The first power line PL1 may extend to the second area AA2 via the bending area BA. The first power line PL1 may extend toward the lower end of the second area AA2 when viewed from above the plane. The first power line PL1 may receive a first voltage.

The second power line PL2 may be disposed in the non-display areas NDA adjacent to the long sides of the first area AA1 and in the non-display area NDA facing the second area AA2 with the display area DA therebetween. The second power line PL2 may be disposed outward of the scan driver SDV and the emission driver EDV.

The second power line PL2 may extend to the second area AA2 via the bending area BA. In the second area AA2, the second power line PL2 may extend in the first direction DR1 on the opposite sides of the data driver DDV. The second power line PL2 may extend toward the lower end of the second area AA2 when viewed from above the plane.

The second power line PL2 may receive a second voltage having a lower level than the first voltage. Although a connection relationship is not illustrated for convenience of description, the second power line PL2 may extend to the display area DA and may be connected to the pixels PX, and the second voltage may be provided to the pixels PX through the second power line PL2.

The connecting lines CNL may extend in the second direction DR2 and may be arranged in the first direction DR1. The connecting lines CNL may be connected to the first power line PL1 and the pixels PX. The first voltage may be applied to the pixels PX through the first power line PL1 and the connecting lines CNL connected with one another.

The first control line CSL1 may be connected to the scan driver SDV and may extend toward the lower end of the second area AA2 via the bending area BA. The second control line CSL2 may be connected to the emission driver EDV and may extend toward the lower end of the second area AA2 via the bending area BA. The data driver DDV may be disposed between the first control line CSL1 and the second control line CSL2.

The pads PD may be disposed adjacent to the lower end of the second area AA2 when viewed from above the plane. The data driver DDV, the first power line PL1, the second power line PL2, the first control line CSL1, and the second control line CSL2 may be connected to the pads PD.

The data lines DL1 to DLn may be connected to corresponding pads PD through the data driver DDV. For example, the data lines DL1 to DLn may be connected to the data driver DDV, and the data driver DDV may be connected to the pads PD that correspond to the data lines DL1 to DLn, respectively.

The display device DD may include a printed circuit board PCB connected to the pads PD. Connecting pads PCB-PD may be disposed on the printed circuit board PCB. The connecting pads PCB-PD may be connected to the pads PD.

A timing controller (not illustrated) may be disposed on the printed circuit board PCB. The timing controller may be connected to the pads PD through the printed circuit board. The timing controller may control operations of the scan driver SDV, the data driver DDV, and the emission driver EDV. The timing controller may generate a scan control signal, a data control signal, and an emission control signal in response to control signals received from the outside.

The scan control signal may be provided to the scan driver SDV through the first control line CSL1. The emission control signal may be provided to the emission driver EDV through the second control line CSL2. The data control signal may be provided to the data driver DDV. The timing controller may receive image signals from the outside, may convert the data format of the image signals according to the specification of an interface with the data driver DDV, and may provide the converted signals to the data driver DDV.

The scan driver SDV may generate a plurality of scan signals in response to the scan control signal. The scan signals may be applied to the pixels PX through the scan lines SL1 to SLm. The scan signals may be sequentially applied to the pixels PX.

The data driver DDV may generate a plurality of data voltages corresponding to the image signals in response to the data control signal. The data voltages may be applied to the pixels PX through the data lines DL1 to DLn. The emission driver EDV may generate a plurality of emission signals in response to the emission control signal. The emission signals may be applied to the pixels PX through the emission lines EL1 to ELm.

The pixels PX may receive the data voltages in response to the scan signals. The pixels PX may display an image by emitting light having luminance corresponding to the data voltages in response to the emission signals. The light emission time of the pixels PX may be controlled by the emission signals.

A voltage generator (not illustrated) may be disposed on the printed circuit board PCB. The voltage generator may be connected to the pads PD through the printed circuit board. The voltage generator may generate the first voltage and the second voltage. The first voltage and the second voltage may be applied to the first power line PL1 and the second power line PL2, respectively.

Each of the pixels PX may include a light emitting element. The first voltage may be applied to an anode of the light emitting element, and the second voltage may be applied to a cathode of the light emitting element. The light emitting element may operate by receiving the first voltage and the second voltage.

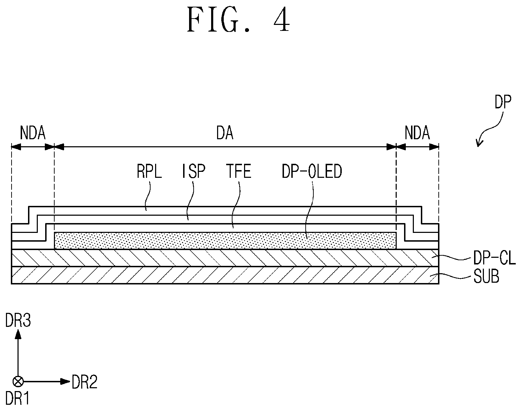

FIG. 4 is a sectional view of the display panel illustrated in FIG. 3.

In FIG. 4, a cross-section of the display panel DP viewed in the first direction DR1 is illustrated.

Referring to FIG. 4, the display panel DP may include a substrate SUB, a circuit element layer DP-CL disposed on the substrate SUB, a display element layer DP-OLED disposed on the circuit element layer DP-CL, a thin film encapsulation layer TFE disposed on the display element layer DP-OLED, an input sensing part ISP disposed on the thin film encapsulation layer TFE, and an anti-reflective layer RPL disposed on the input sensing part ISP. The display element layer DP-OLED may be disposed on the display area DA.

The substrate SUB may include a display area DA and a non-display area NDA around the display area DA. The substrate SUB may include a flexible plastic material. For example, the substrate SUB may include polyimide (PI).

The circuit element layer DP-CL may include transistors. The display element layer DP-OLED may include light emitting elements connected to the transistors. The pixels PX illustrated in FIG. 3 may include the transistors and the light emitting elements.

The thin film encapsulation layer TFE may be disposed on the circuit element layer DP-CL and cover the display element layer DP-OLED. The thin film encapsulation layer TFE may include an inorganic layer, an organic layer, and an in organic layer sequentially stacked one above another. The inorganic layers may include an inorganic material and may protect the pixels from moisture/oxygen. The organic layer may include an organic material and may protect the pixels PX from foreign matter such as, for example, dust particles.

The input sensing part ISP may include a plurality of sensors (not illustrated) for sensing an external input. The sensors may sense the external input in a capacitance type. The external input may include various types of inputs such as, for example, a part of the user's body, light, heat, a pen, pressure, and the like.

The input sensing part ISP may be directly manufactured on the thin film encapsulation layer TFE when the display panel DP is manufactured. However, without being limited thereto, the input sensing part ISP may be manufactured as a panel separate from the display panel DP and may be attached to the display panel DP by an adhesive layer.

The anti-reflective layer RPL may be disposed on the input sensing part ISP. The anti-reflective layer RPL may be attached to the input sensing part ISP by an adhesive layer (not illustrated). The anti-reflective layer RPL may be defined as a film for preventing the reflection of external light. The anti-reflective layer RPL may decrease the reflectance of external light incident toward the display panel DP from the outside.

When external light travelling toward the display panel DP is reflected from the display panel DP and provided back to the user, the user may visually recognize the external light as in a mirror. To prevent such a phenomenon, the anti-reflective layer RPL may include a plurality of color filters that display the same colors as those of the pixels.

The color filters may filter external light into the same colors as those of the pixels. In this case, the external light may not be visible to the user. However, without being limited thereto, the anti-reflective layer RPL may include a phase retarder and/or a polarizer to decrease the reflectance of external light.

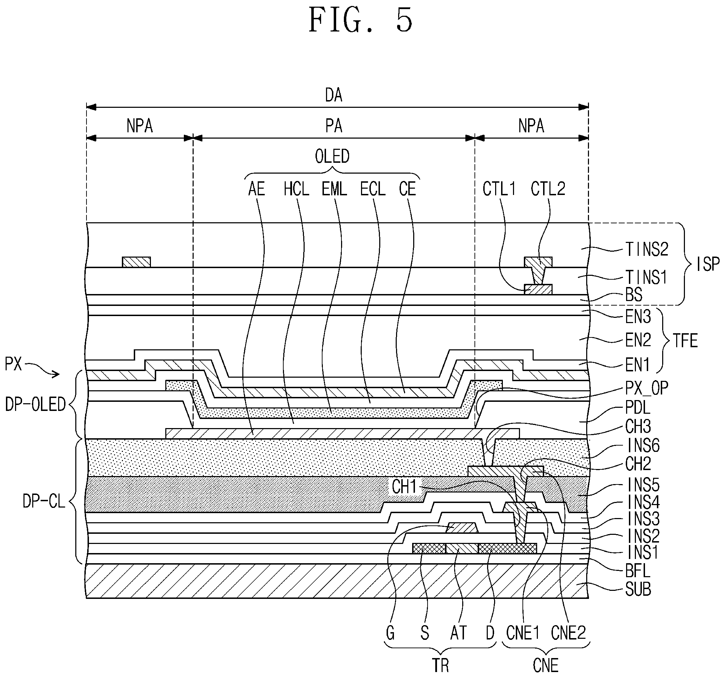

FIG. 5 is a view illustrating a cross-section of the display panel corresponding to one pixel in FIG. 4.

In FIG. 5, the anti-reflective layer RPL is omitted.

Referring to FIG. 5, the display panel DP may include a pixel PX, and the pixel PX may include a transistor TR and a light emitting element OLED. The light emitting element OLED may include a first electrode AE (or, an anode), a second electrode CE (or, a cathode), a hole control layer HCL, an electron control layer ECL, and an emissive layer EML.

The transistor TR and the light emitting element OLED may be disposed on the substrate SUB. Although one transistor TR is illustrated as an example, the pixel PX may substantially include a plurality of transistors and at least one capacitor for driving the light emitting element OLED.

The display area DA may include an emissive area PA corresponding to each of the pixels PX and a non-emissive area NPA around the emissive area PA. The light emitting element OLED may be disposed in the emissive area PA.

A buffer layer BFL may be disposed on the substrate SUB. The buffer layer BFL may be an inorganic layer. A semiconductor pattern S, AT, and D of the transistor TR may be disposed on the buffer layer BFL. The semiconductor pattern S, AT, and D may include poly silicon, amorphous silicon, or metal oxide.

The semiconductor pattern S, AT, and D may be doped with an N-type dopant or a P-type dopant. The semiconductor pattern S, AT, and D may include highly-doped areas and a lightly-doped area. The highly-doped areas may have a higher conductivity than the lightly-doped area and may substantially serve as a source electrode and a drain electrode of the transistor TR. The lightly-doped area may substantially correspond to an active (or, channel) area of the transistor.

The semiconductor pattern S, AT, and D may include a source S, an active area AT, and a drain D. The active area AT may be disposed between the source S and the drain D. A first insulating layer INS1 may be disposed on the semiconductor pattern. A gate G of the transistor TR may be disposed on the first insulating layer INS1. A second insulating layer INS2 may be disposed on the gate G. A third insulating layer INS3 may be disposed on the second insulating layer INS2.

To connect the transistor TR and the light emitting element OLED, a connecting electrode CNE may include a first connecting electrode CNE1 and a second connecting electrode CNE2. The first connecting electrode CNE1 may be disposed on the third insulating layer INS3 and may be connected to the drain D through a first contact hole CH1 defined in the first to third insulating layers INS1 to INS3.

A fourth insulating layer INS4 may be disposed on the first connecting electrode CNE1. A fifth insulating layer INS5 may be disposed on the fourth insulating layer INS4. The second connecting electrode CNE2 may be disposed on the fifth insulating layer INS5. The second connecting electrode CNE2 may be connected to the first connecting electrode CNE1 through a second contact hole CH2 defined in the fourth insulating layer INS4 and the fifth insulating layer INS5.

A sixth insulating layer INS6 may be disposed on the second connecting electrode CNE2. The layers from the buffer layer BFL to the sixth insulating layer INS6 may be defined as the circuit element layer DP-CL. The first to sixth insulating layers INS1 to INS6 may be inorganic layers or organic layers.

The first electrode AE may be disposed on the sixth insulating layer INS6. The first electrode AE may be connected to the second connecting electrode CNE2 through a third contact hole CH3 defined in the sixth insulating layer INS6. A pixel defining layer PDL having an opening PX_OP defined therein to expose a certain portion of the first electrode AE may be disposed on the first electrode AE and the sixth insulating layer INS6.

The hole control layer HCL may be disposed on the first electrode AE and the pixel defining layer PDL. The hole control layer HCL may include a hole transport layer and a hole injection layer.

The emissive layer EML may be disposed on the hole control layer HCL. The emissive layer EML may be disposed in an area corresponding to the opening PX_OP. The emissive layer EML may include an organic material and/or an inorganic material. The emissive layer EML may generate one of red light, green light, and blue light.

The electron control layer ECL may be disposed on the emissive layer EML and the hole control layer HCL. The electron control layer ECL may include an electron transport layer and an electron injection layer. The hole control layer HCL and the electron control layer ECL may be commonly disposed in the emissive area PA and the non-emissive area NPA.

The second electrode CE may be disposed on the electron control layer ECL. The second electrode CE may be commonly disposed in the pixels PX. The layer in which the light emitting element OLED is disposed may be defined as the display element layer DP-OLED.

The thin film encapsulation layer TFE may be disposed on the second electrode CE and may cover the pixel PX. The thin film encapsulation layer TFE may include a first encapsulation layer EN1 disposed on the second electrode CE, a second encapsulation layer EN2 disposed on the first encapsulation layer EN1, and a third encapsulation layer EN3 disposed on the second encapsulation layer EN2.

The first encapsulation layer EN1 and the third encapsulation layer EN3 may include an inorganic insulating layer and may protect the pixel PX from moisture/oxygen. The second encapsulation layer EN2 may include an organic insulating layer and may protect the pixel PX from foreign matter such as, for example, dust particles.

The first voltage may be applied to the first electrode AE through the transistor TR, and the second voltage having a lower level than the first voltage may be applied to the second electrode CE. Holes and electrons injected into the emissive layer EML may be combined to form excitons, and as the excitons transition to a ground state, the light emitting element OLED may emit light.

The layers from the substrate SUB to the thin film encapsulation layer TFE may be defined as the display panel DP. The input sensing part ISP may be disposed on the thin film encapsulation layer TFE. The input sensing part ISP may be directly manufactured on the upper surface of the thin film encapsulation layer TFE.

A base layer BS may be disposed on the thin film encapsulation layer TFE. The base layer BS may include an inorganic insulating layer. At least one inorganic insulating layer may be provided on the thin film encapsulation layer TFE as the base layer BS.

The input sensing part ISP may include a first conductive pattern CTL1 and a second conductive pattern CTL2 disposed over the first conductive pattern CTL1. The first conductive pattern CTL1 may be disposed on the base layer BS. A first insulating layer TINS1 may be disposed on the base layer BS and cover the first conductive pattern CTL1. The first insulating layer TINS1 may include an inorganic insulating layer or an organic insulating layer.

The second conductive pattern CTL2 may be disposed on the first insulating layer TINS1. A second insulating layer TINS2 may be disposed on the first insulating layer TINS1 and cover the second conductive pattern CTL2. The second insulating layer TINS2 may include an organic insulating layer.

The first conductive pattern CTL1 and the second conductive pattern CTL2 may overlap the non-emissive area NPA. Although not illustrated, the first conductive pattern CTL1 and the second conductive pattern CTL2 may be disposed on the non-emissive area NPA between the emissive areas PA and may have a mesh shape.

The first conductive pattern CTL1 and the second conductive pattern CTL2 may form the sensors of the input sensing part ISP described herein. For example, the first conductive pattern CTL1 and the second conductive pattern CTL2 having a mesh shape may be separated from each other in a certain area to form the sensors. A portion of the second conductive pattern CTL2 may be connected to the first conductive pattern CTL1.

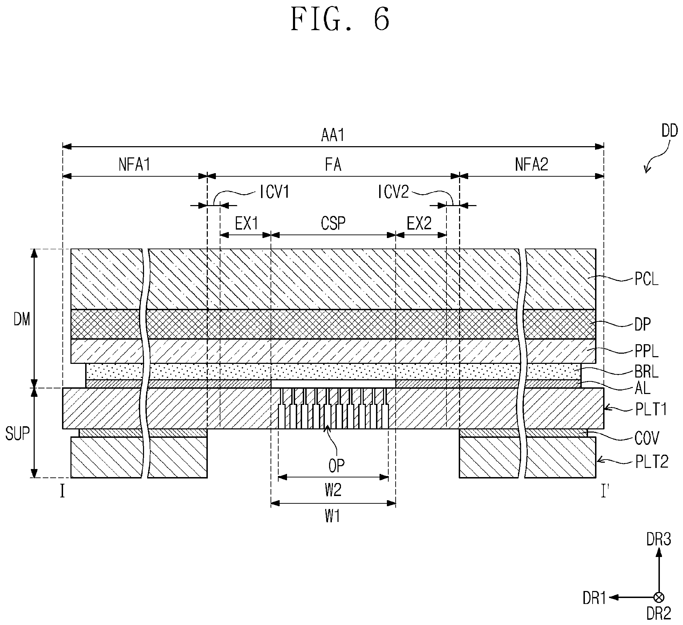

FIG. 6 is a sectional view of the display device corresponding to line I-I' illustrated in FIG. 3.

Referring to FIG. 6, the display device DD according to an embodiment of the present disclosure may include a display module DM and a support part SUP disposed under the display module DM. The display module DM may be a flexible display module. Likewise to the display panel DP, the display module DM may include the first non-folding area NFA1, the folding area FA, and the second non-folding area NFA2 arranged in the first direction DR1. The support part SUP may be disposed under the display module DM and may support the display module DM.

Hereinafter, detailed components of the display module DM and the support part SUP will be described based on a flat state of the display device DD.

The display module DM may include the display panel DP, a panel cover layer PCL, a panel protection layer PPL, a barrier layer BRL, and an adhesive layer AL. The panel cover layer PCL may be disposed on the display panel DP. The panel protection layer PPL and the barrier layer BRL may be disposed under the display panel DP.

The panel cover layer PCL may be disposed on the display panel DP and may protect the display panel DP. The panel cover layer PCL may include a window, a window cover layer disposed on the window, and a hard coating layer disposed on the window cover layer. The window may protect the display panel DP from external scratches. The window may have a property of being optically clear. The window may include glass. However, without being limited thereto, the window may include a synthetic resin film.

The window cover layer may be disposed on the window. The window cover layer may include a flexible plastic material such as, for example, polyimide or polyethylene terephthalate. The hard coating layer may be disposed on the upper surface of the window cover layer.

Although not illustrated, adhesive layers may be disposed between the window, the window cover layer, and the display panel DP, and the window, the window cover layer, and the display panel DP may be bonded to one another by the adhesive layers.

The panel protection layer PPL may be disposed under the display panel DP. The panel protection layer PPL may protect a lower portion of the display panel DP. The panel protection layer PPL may include a flexible plastic material. For example, the panel protection layer PPL may include polyethylene terephthalate (PET).

The barrier layer BRL may be disposed under the panel protection layer PPL. The barrier layer BRL may increase resistance to a compressive force caused by external pressing. Accordingly, the barrier layer BRL may serve to prevent deformation of the display panel DP. The barrier layer BRL may include a flexible plastic material such as, for example, polyimide or polyethylene terephthalate.

The barrier layer BRL may have a color that absorbs light. The barrier layer BRL may be black in color. In this case, components disposed under the barrier layer BRL may not be visible when the display module DM is viewed from above the display module DM.

Although not illustrated, adhesive layers may be disposed between the display panel DP, the panel protection layer PPL, and the barrier layer BRL, and the display panel DP, the panel protection layer PPL, and the barrier layer BRL may be bonded to one another by the adhesive layers.

The thickness of the panel cover layer PCL in the third direction DR3 may range from 100 µm to 120 µm and may preferably be 111 µm. The thickness of the display panel DP in the third direction DR3 may range from 55 µm to 67 µm and may preferably be 61 µm.

The thickness of the panel protection layer PPL in the third direction DR3 may range from 45 µm to 55 µm and may preferably be 50 µm. The thickness of the barrier layer BRL in the third direction DR3 may range from 32 µm to 38 µm and may preferably be 35 µm.

The support part SUP may include a first support plate PLT1, a cover layer COV, and a second support plate PLT2.

The adhesive layer AL may be disposed between the barrier layer BRL and the first support plate PLT1. The barrier layer BRL and the first support plate PLT1 may be bonded to each other by the adhesive layer AL. Thus, the support part SUP may be attached to the display module DM.

The first support plate PLT1 may be disposed under the display module DM and may support the display module DM. The first support plate PLT1 may have a higher rigidity than the display module DM. A plurality of openings OP overlapping the folding area FA may be defined in the first support plate PLT1.

The first support plate PLT1 may include a metallic material such as, for example, stainless steel. For example, the first support plate PLT1 may include SUS 304. However, without being limited thereto, the first support plate PLT1 may include various metallic materials. Alternatively, without being limited thereto, the first support plate PLT1 may include a non-metallic material such as, for example, glass or plastic.

The first support plate PLT1 may include a first non-folding part NFP1, a folding part FP, and a second non-folding part NFP2. For example, the boundaries between the first non-folding part NFP1, the folding part FP, and the second non-folding part NFP2 are illustrated by dotted lines on the first support plate PLT1.

The first non-folding part NFP1, the folding part FP, and the second non-folding part NFP2 may be arranged in the first direction DR1. The folding part FP may be disposed between the first non-folding part NFP1 and the second non-folding part NFP2. The openings OP may be defined in the folding part FP.

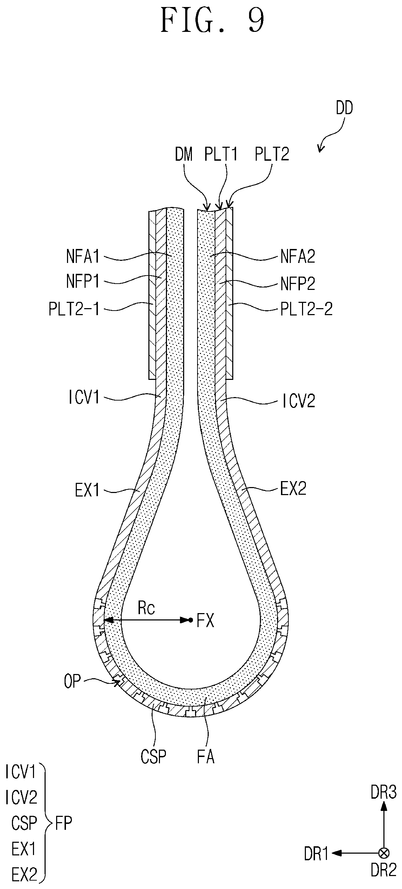

The first non-folding part NFP1 may be disposed under the first non-folding area NFA1 and may overlap the first non-folding area NFA1. The second non-folding part NFP2 may be disposed under the second non-folding area NFA2 and may overlap the second non-folding area NFA2. The folding part FP may be disposed under the folding area FA and may overlap the folding area FA. In an example in which the display device DD is folded, the folding part FP may be folded. A folded state of the folding part FP will be described herein in detail with reference to FIG. 9.

The folding part FP may include a curved portion CSP, a first extension EX1, a second extension EX2, a first reverse curvature portion ICV1, and a second reverse curvature portion ICV2. The boundaries between the curved portion CSP, the first extension EX1, the second extension EX2, the first reverse curvature portion ICV1, and the second reverse curvature portion ICV2 are illustrated by dotted lines on the first support plate PLT1, and for convenience, the reference numerals thereof are illustrated above the display module DM with the dotted boundary lines extended upward.

The curved portion CSP, the first extension EX1, the second extension EX2, the first reverse curvature portion ICV1, and the second reverse curvature portion ICV2 may be arranged in the first direction DR1. For example, the curved portion CSP may be disposed at the center of the folding part FP.

The curved portion CSP may be disposed between the first extension EX1 and the second extension EX2. The openings OP may be defined in the curved portion CSP. The openings OP may be formed through portions of the curved portion CSP in the third direction DR3. Since the openings OP are defined in the curved portion CSP, the flexibility of the curved portion CSP may be increased. In this case, the curved portion CSP may be easily folded when the folding part FP is folded. A folded state of the curved portion CSP will be described herein in detail with reference to FIG. 9.

Between the lower surface and the upper surface of the first support plate PLT1, the width of each of the openings OP defined from the lower surface of the first support plate PLT1 to a certain height may be greater than the width of each of the openings OP defined from the certain height to the upper surface of the first support plate PLT1. In FIG. 6, the width of each of the openings OP may be defined as a numerical value measured in the first direction DR1.

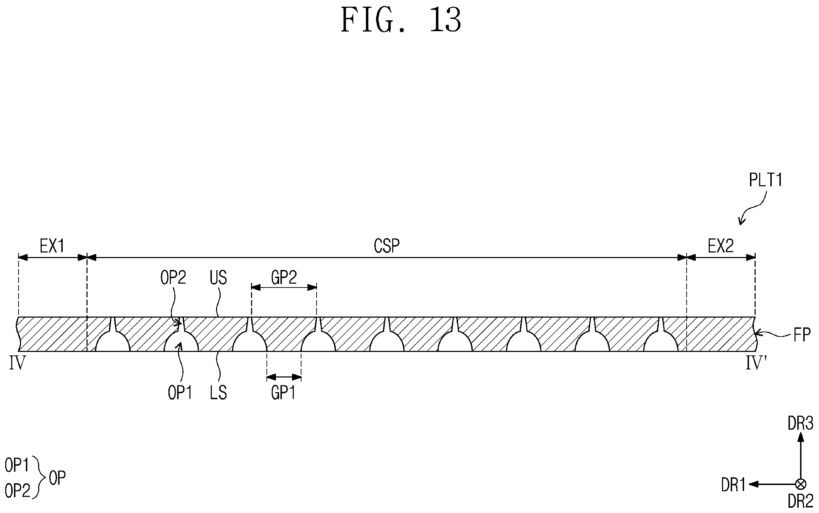

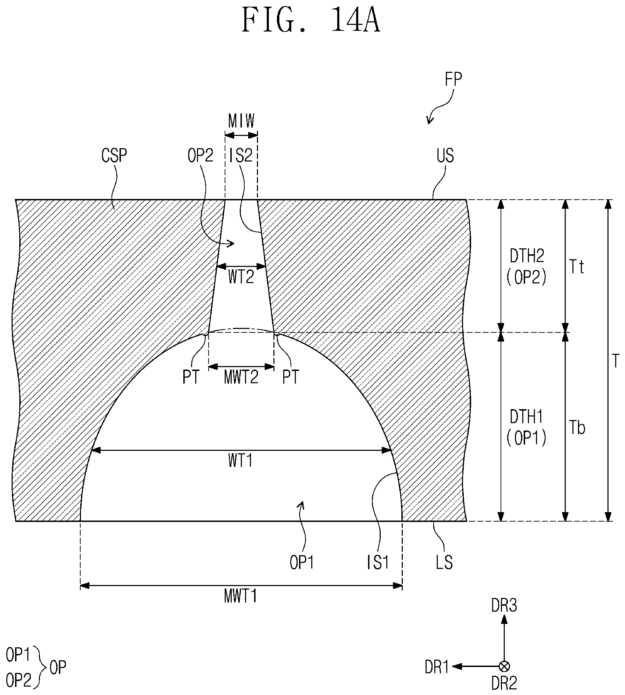

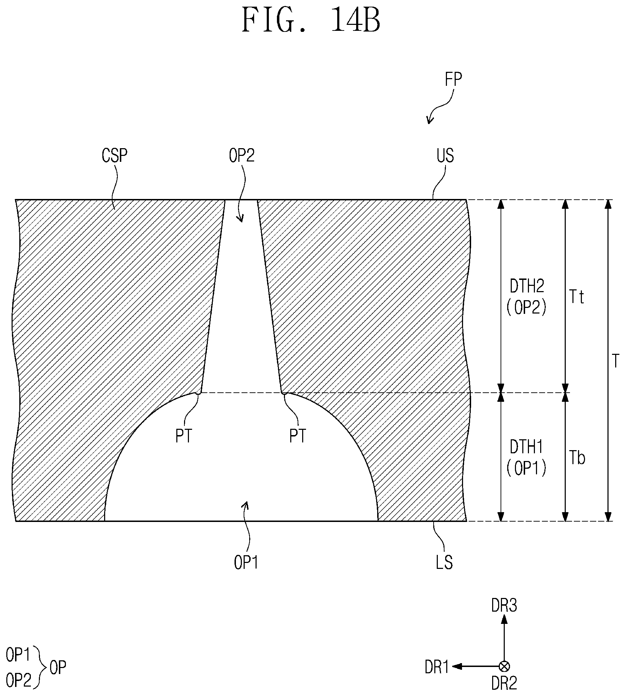

In FIG. 6, the openings OP are schematically illustrated to show the difference in width between the openings OP. For example, in FIG. 6, the inner surfaces of the first support plate PLT1 that define the openings OP are illustrated as vertically extending in the third direction DR3. In order to illustrate the openings OP in a limited narrow area (e.g., the curved portion CSP), the openings OP are illustrated as in FIG. 6. However, the detailed shapes of the openings OP may be formed of a curved surface and an inclined surface. The shapes of the openings OP will be magnified and illustrated in more detail in FIGS. 13 and 14.

To briefly explain the shapes of the openings OP in advance, the inner surfaces of the folding part FP that define the wide portions of the openings OP may have a substantially curved shape. In some aspects, the inner surfaces of the folding part FP that define the narrow portions of the openings OP may be inclined surfaces.

The adhesive layer AL may not overlap the curved portion CSP. That is, an area of the adhesive layer AL that overlaps the curved portion CSP may be open.

The first extension EX1 may be disposed between the first reverse curvature portion ICV1 and the curved portion CSP, and the second extension EX2 may be disposed between the second reverse curvature portion ICV2 and the curved portion CSP. The first reverse curvature portion ICV1 may be disposed between the first extension EX1 and the first non-folding part NFP1. The second reverse curvature portion ICV2 may be disposed between the second extension EX2 and the second non-folding part NFP2.

The cover layer COV may be disposed under the first support plate PLT1. The cover layer COV may be disposed under the first non-folding part NFP1 and the second non-folding part NFP2 and may overlap the first non-folding part NFP1 and the second non-folding part NFP2.

The cover layer COV may not be disposed under the folding part FP. That is, an area of the cover layer COV that overlaps the folding part FP may be open. Accordingly, the cover layer COV may not be disposed under the curved portion CSP. However, without being limited thereto, the cover layer COV may be disposed under the curved portion CSP and may cover the openings OP.

The cover layer COV may have a lower elastic modulus than the first support plate PLT1. For example, the cover layer COV may include thermoplastic poly-urethane or rubber, but the material of the cover layer COV is not limited thereto. The cover layer COV may be manufactured in the form of a sheet and may be attached to the first support plate PLT1.

The second support plate PLT2 may be disposed under the first support plate PLT1. The second support plate PLT2 may overlap the first non-folding part NFP1 and the second non-folding part NFP2 and may not overlap the folding part FP. Specifically, the second support plate PLT2 may be disposed under the cover layer COV such that the second support plate PLT2 overlaps the first non-folding part NFP1 and the second non-folding part NFP2.

The second support plate PLT2 may have a higher rigidity than the display module DM. The second support plate PLT2 may include a metal such as, for example, a copper and nickel alloy. However, without being limited thereto, the second support plate PLT2 may include various metallic materials. The second support plate PLT2 may have a heat dissipation function.

The second support plate PLT2 may include a second-first support plate PLT2-1 and a second-second support plate PLT2-2 arranged in the first direction DR1. The second-first support plate PLT2-1 may be disposed under the first non-folding part NFP1 and may overlap the first non-folding part NFP1. The second-second support plate PLT2-2 may be disposed under the second non-folding part NFP2 and may overlap the second non-folding part NFP2.

The second-first support plate PLT2-1 and the second-second support plate PLT2-2 may supplement a support function of the first support plate PLT1 that supports the display module DM. For example, the second-first support plate PLT2-1 may support the first non-folding area NFA1, and the second-second support plate PLT2-2 may support the second non-folding area NFA2.

Depending on the described structure, the cover layer COV may be disposed between the first support plate PLT1 and the second support plate PLT2. Specifically, the cover layer COV may be disposed between the first non-folding part NFP1 and the second-first support plate PLT2-1 and between the second non-folding part NFP2 and the second-second support plate PLT2-2.

Although not illustrated, an adhesive layer may be disposed between the cover layer COV and the second support plate PLT2, and the cover layer COV and the second support plate PLT2 may be bonded to each other by the adhesive layer.

The first support plate PLT1 may have a greater thickness in the third direction DR3 than the second support plate PLT2. The thickness of the first support plate PLT1 in the third direction DR3 may range from 90 µm to 110 µm and may preferably be 100 µm. The thickness of the second support plate PLT2 in the third direction DR3 may range from 77 µm to 95 µm and may preferably be 86 µm. The thickness of the cover layer COV may range from 14 µm to 18 µm and may preferably be 16 µm.

The opening (reference numeral not illustrated) of the adhesive layer AL may have a first width W1 of 12.95 mm in the first direction DR1. The area where the openings OP are formed may have a second width W2 of 11.12 mm in the first direction DR1.

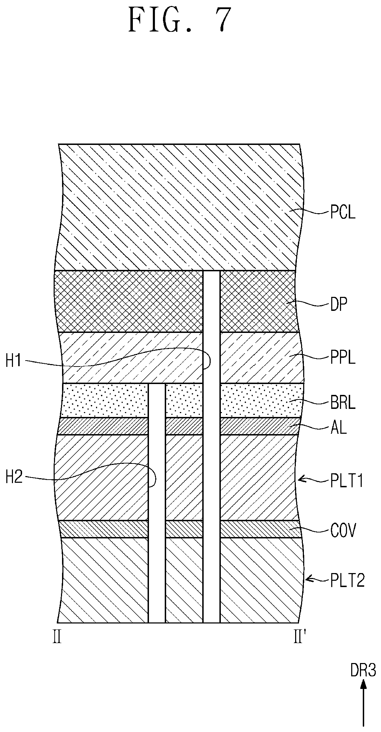

FIG. 7 is a sectional view taken along line II-II' illustrated in FIG. 3.

Referring to FIG. 7, a first hole H1 and a second hole H2 may be defined in the support part SUP and the display module DM.

The first hole H1 may be defined from the second support plate PLT2 to the display panel DP. For example, the first hole H1 may be defined in the second support plate PLT2, the cover layer COV, the first support plate PLT1, the barrier layer BRL, the panel protection layer PPL, and the display panel DP.

The second hole H2 may be defined from the second support plate PLT2 to the barrier layer BRL. For example, the second hole H2 may be defined in the second support plate PLT2, the cover layer COV, the first support plate PLT1, and the barrier layer BRL.

The described camera CM may be disposed in the first hole H1. The described sensor SN may be disposed in the second hole H2. Optical signals may be provided to the camera CM and the sensor SN through the first hole H1 and the second hole H2.

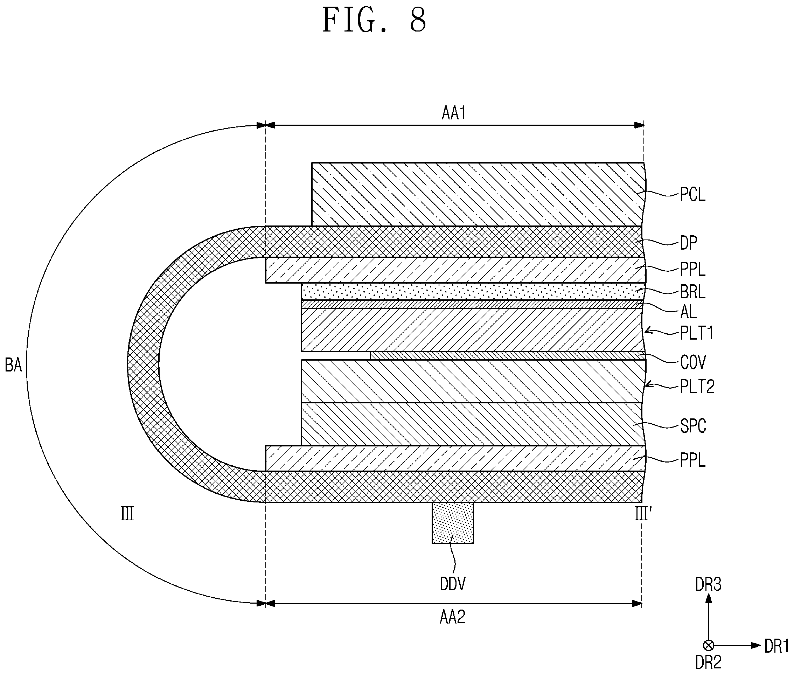

FIG. 8 is a sectional view taken along line III-III' illustrated in FIG. 3, where FIG. 8 illustrates a state in which the bending area is bent.

Referring to FIG. 8, the data driver DDV may be disposed on the second area AA2. In an example in which the data driver DDV is disposed on the second area AA2, this may mean that the data driver DDV is below the second area AA2 based on the bent state in FIG. 8.

The data driver DDV may be defined as a driver IC. The bending area BA may be bent such that the second area AA2 is disposed under the first area AA1. Accordingly, the data driver DDV may be disposed under the first area AA1. The bending area BA may be bent such that the bending area BA is convex toward the outside of the display panel DP. The bending area BA may be bent to have a certain curvature.

The panel protection layer PPL may not be disposed in an area overlapping the bending area BA. Since the panel protection layer PPL is not disposed under the bending area BA, the bending area BA may be more easily bent. If the panel protection layer PPL is also disposed under the bending area BA, the area where the bending area BA is disposed may have an increased thickness, and therefore the increased thickness may result in increased difficulty associated with bending the bending area BA.

A spacer SPC may be disposed between the panel protection layer PPL on the second area AA2 and the second support plate PLT2.

The spacer SPC may be a double-sided tape. For example, the spacer SPC may include a base layer such as, for example, polyethylene terephthalate having flexibility and an adhesive disposed on the upper and lower surfaces of the base layer.

FIG. 9 is a view illustrating a folded state of the display device illustrated in FIG. 6.

In FIG. 9, the display module DM is illustrated as a single layer. In some aspects, for convenience of description, the first support plate PLT2, the second support plate PLT2, a first wing plate WPT1, a second wing plate WPT2, a first flat plate PPT1, a second flat plate PPT2, a first sub-wing plate SWPT1, a second sub-wing plate SWPT2, and a center plate CPT are illustrated together with the display module DM, and other components are omitted.

Referring to FIG. 9, the first support plate PLT1 may be folded about the folding axis FX. The first support plate PLT1 may be folded in a dumbbell shape. As the first support plate PLT1 is folded, the display module DM may be folded together with the first support plate PLT1.

The folding part FP may be folded about the folding axis FX, and the first support plate PLT1 may be folded accordingly. In an example in which the folding part FP is folded, the curved portion CSP may be bent to have a certain curvature. The curved portion CSP may be bent to have a certain radius of curvature Rc. As the folding part FP is folded, the folding area FA may be folded.

The first reverse curvature portion ICV1 may be bent opposite to the curved portion CSP. The second reverse curvature portion ICV2 may be bent opposite to the curved portion CSP. The second reverse curvature portion ICV2 may have a shape symmetrical to a shape of the first reverse curvature portion ICV1.

When the folding part FP is folded, the first non-folding part NFP1, the second non-folding part NFP2, the second-first support plate PLT2-1, and the second-second support plate PLT2-2 may remain flat. Accordingly, the first non-folding area NFA1 and the second non-folding area NFA2 may be maintained in a flat state by the first non-folding part NFP1, the second non-folding part NFP2, the second-first support plate PLT2-1, and the second-second support plate PLT2-2.

When the folding part FP is folded, the distance between the first non-folding part NFP1 and the second non-folding part NFP2 in the first direction DR1 may be less than the diameter of a circle having the radius of curvature Rc. Depending on the described configuration, the first support plate PLT1 may be folded in a dumbbell shape.

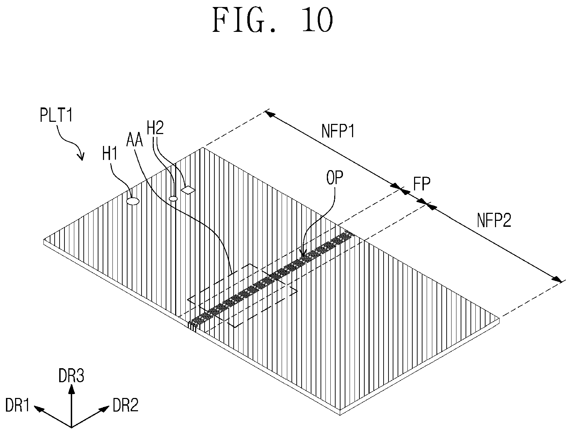

FIG. 10 is a perspective view of the first support plate illustrated in FIG. 6.

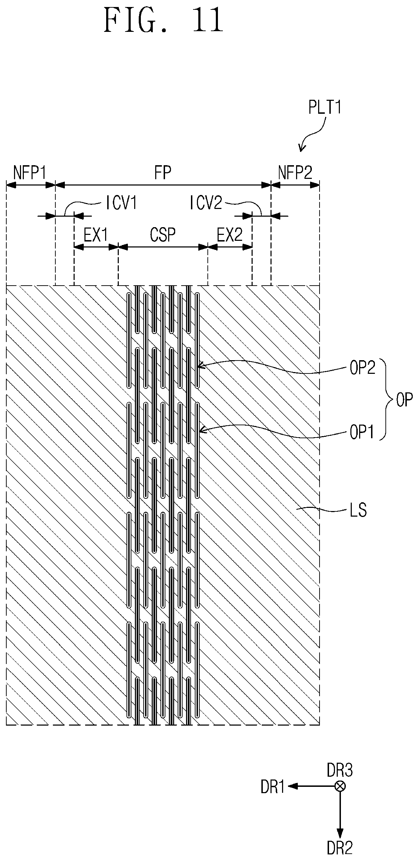

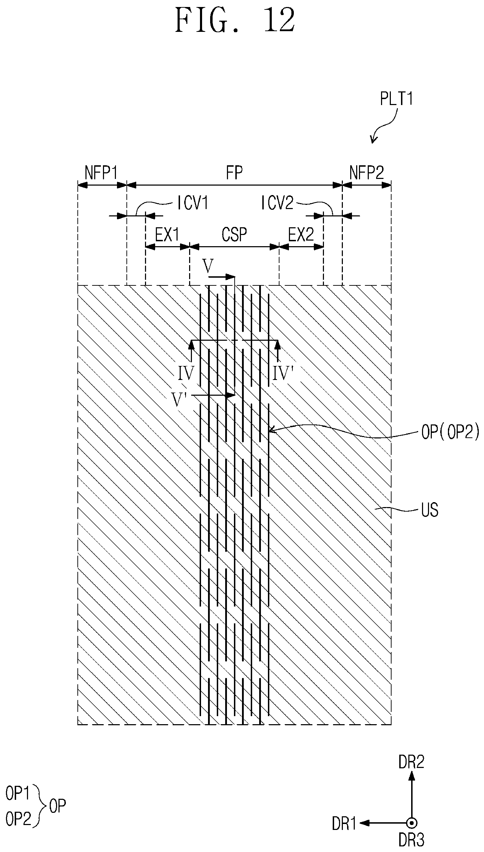

Referring to FIG. 10, the first support plate PLT1 may include the first non-folding part NFP1, the folding part FP, and the second non-folding part NFP2 arranged in the first direction DR1. The openings OP defined in the folding part FP may be arranged in a grid form. The arrangement of the openings OP will be illustrated in more detail in FIGS. 11 and 12.

The first hole H1 and the second holes H2 may be defined in the first non-folding part NFP1. The first hole H1 and the second holes H2 may be adjacent to the periphery of the first non-folding part NFP1. The first hole H1 may correspond to the first hole H1 illustrated in FIG. 7, and the described camera CM may be disposed in the first hole H1. The second holes H2 may correspond to the second hole H2 illustrated in FIG. 7, and the described sensors SN may be disposed in the second holes H2.

FIG. 11 is an enlarged view of area AA illustrated in FIG. 10 when the first support plate illustrated in FIG. 10 is viewed from below. FIG. 12 is an enlarged view of area AA illustrated in FIG. 10 when the first support plate illustrated in FIG. 10 is viewed from above.

Referring to FIGS. 11 and 12, the folding part FP may include the first reverse curvature portion ICV1, the first extension EX1, the curved portion CSP, the second extension EX2, and the second reverse curvature portion ICV2 arranged in the first direction DR1.

A grid pattern may be defined in the curved portion CSP. For example, the openings OP defined in the curved portion CSP may be arranged in a grid form to define the grid pattern of the curved portion CSP.

The openings OP may be arranged in the first direction DR1 and the second direction DR2. The openings OP may extend longer in the second direction DR2 than in the first direction DR1. The openings OP disposed in the h^{th} column and the openings OP disposed in the (h+1)^{th} column may be staggered with respect to each other. "h" may be a natural number, and the columns may correspond to the second direction DR2.

The openings OP may include a plurality of first openings OP1 and a plurality of second openings OP2. The first openings OP1 may be defined in the lower surface LS of the folding part FP. The second openings OP2 may be defined in the upper surface US of the folding part FP.

The first openings OP1 may be arranged in the first direction DR1 and the second direction DR2. The first openings OP1 may extend longer in the second direction DR2 than in the first direction DR1. The first openings OP1 disposed in the h^{th} column and the first openings OP1 disposed in the (h+1)^{th} column may be staggered with respect to each other.

The second openings OP2 may be arranged in the first direction DR1 and the second direction DR2. The second openings OP2 may extend longer in the second direction DR2 than in the first direction DR1. The second openings OP2 disposed in the h^{th} column and the second openings OP2 disposed in the (h+1)^{th} column may be staggered with respect to each other.

Referring to FIG. 11, the second openings OP2 may overlap the first openings OP1, respectively, when viewed from above the plane. In some aspects, the second openings OP2 may be disposed in the first openings OP1, respectively, when viewed from above the plane. In the first direction DR1, the width of each of the first openings OP1 may be greater than the width of each of the second openings OP2. In the second direction DR2, the length of each of the first openings OP1 may be greater than the length of each of the second openings OP2. However, without being limited thereto, the length of each of the second openings OP2 may be smaller than the length of each of the first openings OP1.

FIG. 13 is a sectional view taken along line IV-IV' illustrated in FIG. 12.

Referring to FIGS. 12 and 13, the openings OP may be arranged in the first direction DR1 and may be defined to penetrate portions of the curved portion CSP in the third direction DR3. The openings OP may have different shapes depending on the position of the curved portion CSP in the third direction DR3. The openings OP may include the first openings OP1 and the second openings OP2 that have different shapes.

The first openings OP1 may be defined in the lower surface LS of the curved portion CSP and may extend in the third direction DR3. The second openings OP2 may be defined above the first openings OP1, respectively. The second openings OP2 may be defined in the upper surface US of the curved portion CSP and may extend in the third direction DR3. The first openings OP1 and the second openings OP2 may be defined such that the first openings OP1 and the second openings OP2 are continuous with each other in the third direction DR3.

The first openings OP1 may be spaced apart from one another at equal intervals in the first direction DR1. However, without being limited thereto, the first openings OP1 may be spaced apart from one another at various intervals in the first direction DR1.

The second openings OP2 may be spaced apart from one another at equal intervals in the first direction DR1. However, without being limited thereto, the second openings OP2 may be spaced apart from one another at various intervals in the first direction DR1.

Based on the lower surface LS of the curved portion CSP, the first openings OP1 may be equally spaced apart from one another at first intervals GP1. For example, the interval between two first openings OP1 adjacent to each other may be defined as the first interval GP1. The first interval GP1 may be defined as a numerical value measured in the first direction DR1.

For example, the first interval GP1 may be 100 micrometers (µm). However, the numerical value of the first interval GP1 is not limited thereto. The first interval GP1 may be equal to the maximum width of each of the first openings OP1 that is measured in the first direction DR1. The maximum width of the first opening OP1 may be defined as the width of the first opening OP1 measured based on the lower surface LS of the curved portion CSP.

Based on the upper surface US of the curved portion CSP, the second openings OP2 may be equally spaced apart from one another at second intervals GP2. For example, the interval between two second openings OP2 adjacent to each other may be defined as the second interval GP2. The second interval GP2 may be defined as a numerical value measured in the first direction DR1. For example, the second interval GP2 may be 180 micrometers (µm). However, the numerical value of the second interval GP2 is not limited thereto.

FIG. 14A is an enlarged view of one of the openings illustrated in FIG. 13. FIG. 14B is a view illustrating a structure in which the first depth and the second depth are set differently from the first depth and the second depth as illustrated in FIG. 14A.

In FIG. 14A, the boundary between the first opening OP1 and the second opening OP2 is illustrated by a dotted line extending in the first direction DR1. In some aspects, a virtual curve adjacent to the boundary between the first opening OP1 and the second opening OP2 and continuously defined along the periphery of the first opening OP1 is illustrated by a dash-dot-dash line.

Referring to FIG. 14A, the folding part FP may include a first inner surface IS1 that defines the first opening OP1 and a second inner surface IS2 that defines the second opening OP2. Specifically, the curved portion CSP of the folding part FP may include the first inner surface IS 1 and the second inner surface IS2.

The first inner surface IS1 may have a curved shape. The second inner surface IS2 may have an inclined surface that forms a certain angle with the third direction DR3 and extends in a straight-line shape. For example, the second inner surface IS2 may form an acute angle with respect to the upper surface US of the curved portion CSP.

The first inner surface IS1 may have a concave shape. Depending on the shape of the first inner surface IS1, the first opening OP1, when viewed in the second direction DR2, may have a shape that is convex upward. Depending on the shape of the second inner surface IS2, the second opening OP2, when viewed in the second direction DR2, may have a trapezoidal shape.

The first opening OP1 may have a first width WT1 in the first direction DR1, and the second opening OP2 may have a second width WT2 in the first direction DR1. The first width WT1 and the second width WT2 may be defined as numerical values measured in the first direction DR1. The first width WT1 and the second width WT2 may be different from each other.

The first width WT1 may be defined as a gap between the first inner surfaces IS1 facing each other in the first direction DR1. The second width WT2 may be defined as a gap between the second inner surfaces IS2 facing each other in the first direction DR1.

The first width WT1 may gradually decrease in the third direction DR3, from bottom to top of the display device DD. For example, the first inner surface IS1 may have a curved shape, and the reduction rate of the first width WT1 of the first opening OP1 may be varied similar to a reduction rate of a quadratic function curve.

The second width WT2 may gradually decrease in the third direction DR3, from bottom to top of the display device DD. For example, the second inner surface IS2 may have a straight-line shape, and the reduction rate of the second width WT2 of the second opening OP2 may be constant similar to a reduction rate of a linear function line.

The first width WT1 may be varied, the second width WT2 may be varied, and the first width WT1 may be greater than the second width WT2. That is, the first opening OP1 may be defined such that the first opening OP1 is larger than the second opening OP2. Hereinafter, in this specification, a thickness may be defined as a numerical value measured in the third direction DR3. The thickness T of the folding part FP may be defined as the thickness T of the first support plate PLT1. For example, the thickness T of the first support plate PLT1 may be greater than 0 micrometers (µm) and less than or equal to 150 micrometers (µm). In an example case in which the thickness of the first support plate PLT1 increases, the thickness and weight of the display device DD may increase, and therefore the commercial value of the display device DD targeting slimness and weight reduction may be lowered. In an example case in which the thickness of the first support plate PLT1 increases, the bending stiffness of the folding part FP may increase, and therefore folding performance of the display device DD may be deteriorated. In some aspects, when the bending stiffness of the folding part FP increases, stress on the folding part FP may increase during a folding operation of the folding part FP, and therefore the folding part FP may be damaged. In an example in which the first support plate PLT1 includes metal, the first support plate PLT1 may have a thickness less than or equal to 150 micrometers (µm) as an appropriate thickness that does not impair the commercial value.

The first opening OP1 may have a first depth DTH1 in the third direction DR3, and the second opening OP2 may have a second depth DTH2 in the third direction DR3. Based on the lower surface LS of the curved portion CSP, the first depth DTH1 may be defined in a direction that is perpendicular to the lower surface LS and is oriented toward the inside of the curved portion CSP. Based on the upper surface US of the curved portion CSP, the second depth DTH2 may be defined in a direction that is perpendicular to the upper surface US and is oriented toward the inside of the curved portion CSP.

The first thickness Tb of the portion of the folding part FP in which the first opening OP1 is defined may be equal to the first depth DTH1. The second thickness Tt of the portion of the folding part FP in which the second opening OP2 is defined may be equal to the second depth DTH2.

The second thickness Tt may be greater than 0 micrometers (µm) and less than or equal to a first value obtained by multiplying the thickness T by 0.3 or a second value obtained by multiplying the thickness T by 0.7. The first thickness Tb may have a value obtained by subtracting the second thickness Tt from the thickness T.

The minimum width MIW of the second width WT2 may be greater than 0 micrometers (µm) and less than or equal to 50 micrometers (µm). The minimum width MIW may be defined as a portion of the second opening OP2 defined in the upper surface US.

As the minimum width MIW increases, the durability of the folding part FP may be lowered. As the minimum width MIW decreases, the folding operation of the folding part FP may be difficult. The second gap illustrated in FIG. 13 may be defined as a rib width. In an example in which the second gap GP2 has a value ranging from 50 micrometers (µm) to 250 micrometers (µm), the minimum width MIW may be greater than 0 micrometers (µm) and less than or equal to 40 micrometers (µm).

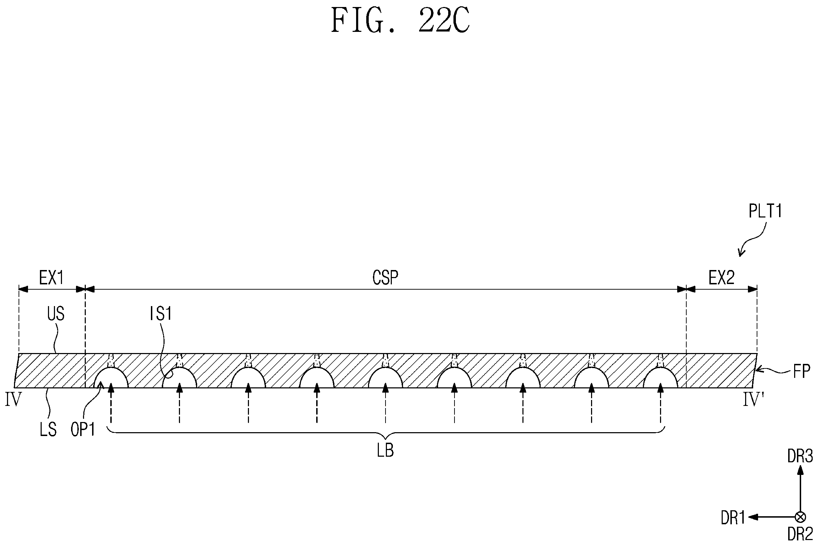

In some embodiments, the minimum width MIW may be set to a value greater than 0 micrometers (µm) and less than or equal to 40 micrometers (µm), which may support the folding part FP having a target or appropriate durability. However, the minimum width MIW may be substantially set to a value greater than 0 micrometers (µm) and less than or equal to 50 micrometers (µm) in view of the fact that the second opening OP2 is formed by a laser process (illustrated in FIG. 22C) and the processing tolerance for the laser process is 10 micrometers (µm).

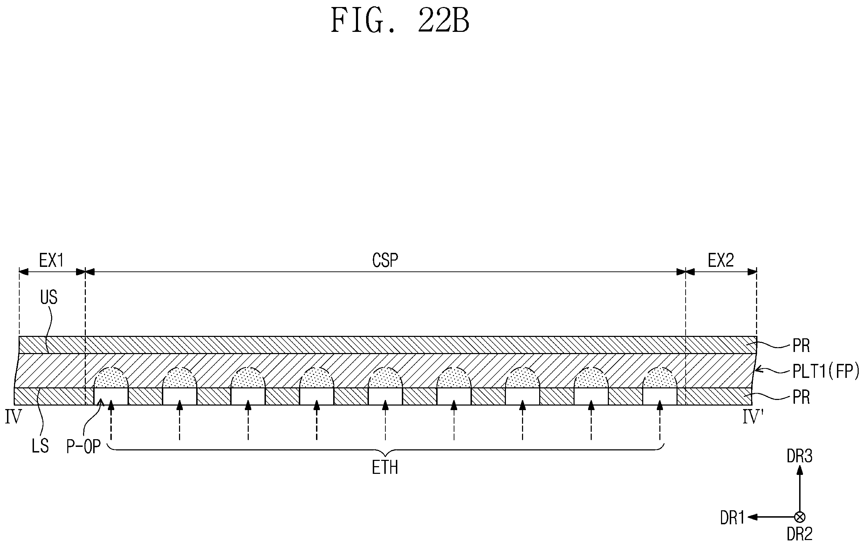

The first opening OP1 may be formed by a photoresist process (illustrated in FIG. 22B). In this case, the width of the first opening OP1 may be determined depending on the depth of the first opening OP1. That is, the maximum width MWT1 of the first width WT1 may be determined depending on the first thickness Tb. For example, the maximum width MWT1 of the first width WT1 may be greater than 0 micrometers (µm) and less than or equal to a third value obtained by dividing the first thickness Tb by 0.6 or a fourth value obtained by dividing the first thickness Tb by 0.3. The maximum width MWT1 may be defined as a portion of the first opening OP1 defined in the lower surface LS.

Under the condition that the maximum width MWT1 is greater than the minimum width MIW, the minimum width MIW may have a value in the numerical range described herein, and the maximum width MWT1 may have a value in the numerical range.

For example, the first width WT1 may range from 20 micrometers (µm) to 100 micrometers (µm). In this case, the maximum width MWT1 of the first width WT1 may be set to 100 micrometers (µm).

For example, the second width WT2 may range from 10 micrometers (µm) to 20 micrometers (µm). In this case, the maximum width MWT2 of the second width WT2 may be set to 20 micrometers (µm), and the minimum width MIW of the second width WT2 may be set to 10 micrometers (µm).

The numerical ranges of the first width WT1 and the second width WT2 are described as examples, and the first width WT1 and the second width WT2 may vary depending on the thickness of the first support plate PLT1.

Under the conditions of the numerical range of the first thickness Tb corresponding to the first depth DTH1 and the numerical range of the second thickness Tt corresponding to the second depth DTH2, the first depth DTH1 and the second depth DTH2 may be set to various values. For example, the first depth DTH1 and the second depth DTH2 may be different from each other. That is, the first thickness Tb and the second thickness Tt may be different from each other. Specifically, the first depth DTH1 may be greater than the second depth DTH2. That is, the first thickness Tb may be greater than the second thickness Tt.

For example, the ratio between the first depth DTH1 and the second depth DTH2 may be 6:4. However, without being limited thereto, the ratio between the first depth DTH1 and the second depth DTH2 may be diversely set. For example, referring to FIG. 14B, the first depth DTH1 of the first opening OP1 may be smaller than the second depth DTH2 of the second opening OP2. That is, the first thickness Tb may be smaller than the second thickness Tt. Specifically, in FIG. 14B, the ratio between the first depth DTH1 and the second depth DTH2 may be 4:6. That is, the ratio between the first thickness Tb and the second thickness Tt may be set to 4:6.

For example, the first depth DTH1 may be 60 micrometers, and the second depth DTH2 may be 40 micrometers. However, without being limited thereto, the first depth DTH1 and the second depth DTH2 may have various values depending on the thickness of the first support plate PLT1.

The maximum width MWT1 of the first width WT1 may be greater than the first depth DTH1. The maximum width MWT2 of the second width WT2 may be less than the second depth DTH2.

The folding part FP may further include a protrusion PT that is adjacent to the boundary between the first inner surface IS1 and the second inner surface IS2 and protrudes downward from the first inner surface IS1. The boundary between the first inner surface IS1 and the second inner surface IS2 may substantially correspond to the boundary between the first opening OP1 and the second opening OP2. The term "adjacent" may refer to a first element being within a threshold distance of a second element and/or without an element between the first element and the second element.

The protrusion PT may be formed depending on a process for forming the second opening OP2. The reason why the protrusion PT is formed will be described herein in detail in a manufacturing method of the display device DD according to an embodiment of the present disclosure.

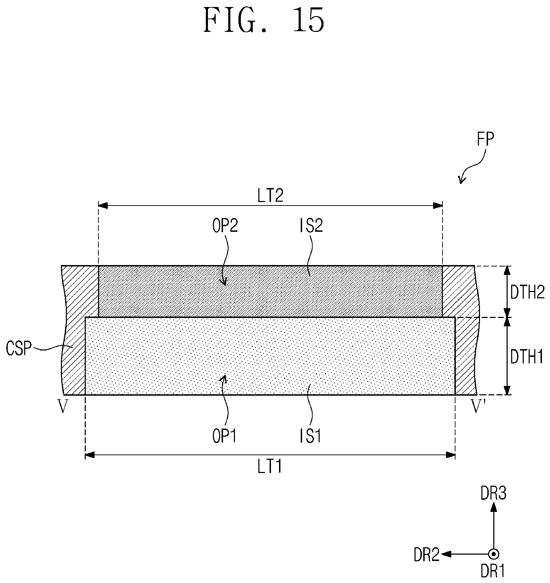

FIG. 15 is a sectional view taken along line V-V' illustrated in FIG. 12.

Referring to FIGS. 12 and 15, the first opening OP1 may have a first length LT1 in the second direction DR2, and the second opening OP2 may have a second length LT2 in the second direction DR2. The first length LT1 and the second length LT2 may be defined as numerical values measured in the second direction DR2. The first length LT1 and the second length LT2 may be different from each other. For example, the second length LT2 may be less than the first length LT1.

The first opening OP1 and the second opening OP2 may be formed through different processes. In an embodiment of the present disclosure, the first opening OP1 may be formed through an etching process, and the second opening OP2 may be formed through a laser process.

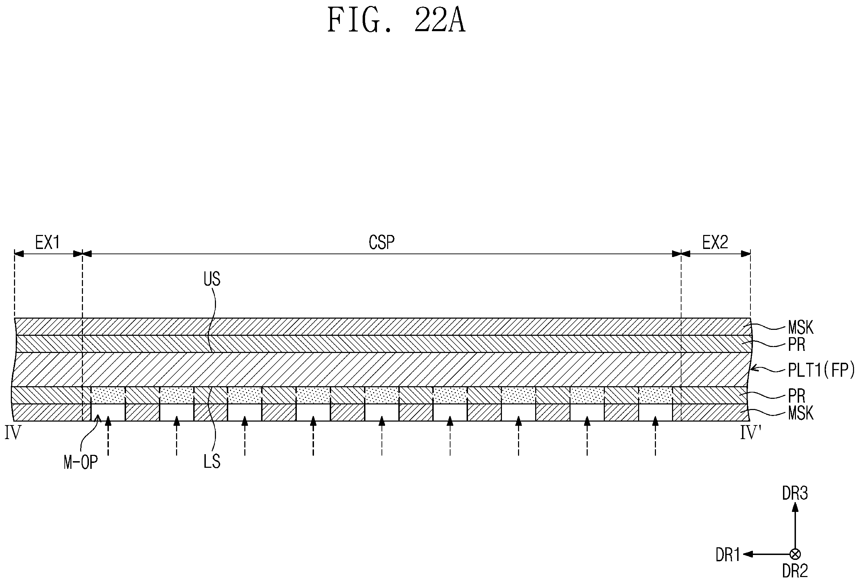

The first opening OP1 may be formed by processing portions of the folding part FP (e.g., portions of the curved portion CSP) using an etching solution. The second opening OP2 may be formed by processing portions of the folding part FP (e.g., portions of the curved portion CSP) using a laser beam. The processing methods will be described herein in detail with reference to FIGS. 22A to 22D.

When the processing methods are different from each other, the surface roughness of the first inner surface IS1 may be different from the surface roughness of the second inner surface IS2. For example, the surface roughness of the first inner surface IS1 may be greater than the surface roughness of the second inner surface IS2.

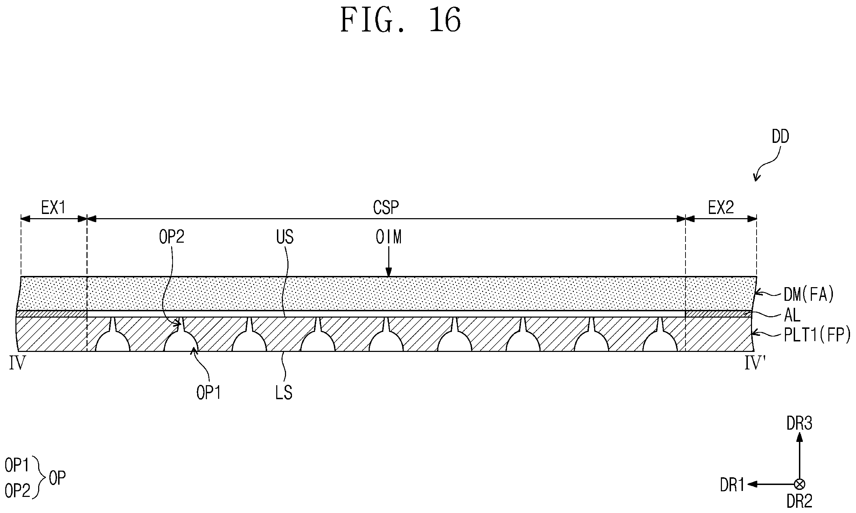

FIG. 16 is a view illustrating the first support plate in which the openings illustrated in FIGS. 13 to 15 are defined and the display module attached to the first support plate.

FIG. 16 illustrates a cross-section corresponding to FIG. 13, and the adhesive layer AL of the display module DM is separately illustrated in FIG. 16. In some aspects, components of the display device DD disposed under the first support plate PLT1 are omitted.

Referring to FIGS. 13 to 16, the second openings OP2 may have a smaller size than the first openings OP1. Accordingly, the area of the upper surface US of the folding part FP may be greater than the area of the lower surface LS of the folding part FP. In this case, the upper surface US of the folding part FP may have a higher rigidity than the lower surface LS of the folding part FP. Specifically, a portion of the curved portion CSP adjacent to the upper surface US of the curved portion CSP may have a higher rigidity than a portion of the curved portion CSP adjacent to the lower surface LS of the curved portion CSP.

As the sizes of the openings OP are increased, the flexibility of the curved portion CSP may be improved, but the curved portion CSP may be easily deformed by external impact OIM (or, external pressure). That is, as the sizes of the openings OP are increased, the support force of the curved portion CSP may be weakened, and therefore the impact resistance of the curved portion CSP may be weakened. Impact resistance may be defined as a property of resisting external impact without being deformed by the external impact.

As the sizes of the openings OP are decreased, the flexibility of the curved portion CSP may be decreased, but the curved portion CSP may not be easily deformed by the external impact OIM. That is, as the sizes of the openings OP are decreased, the support force of the curved portion CSP may be strengthened, and thus the impact resistance of the curved portion CSP may be strengthened.

In an embodiment of the present disclosure, the flexibility of the curved portion CSP may be increased by the first openings OP1 having a greater width than the second openings OP2, and the support force of the curved portion CSP may be improved by the second openings OP having a smaller width than the first openings OP1. Accordingly, when the external impact OIM is applied toward the curved portion CSP from above the display module DM, the deformation of the folding area FA of the display module DM that overlaps the curved portion CSP may be prevented by the curved portion CSP with improved support force. Thus, the impact resistance of the display device DD may be improved.

The widths of the first openings OP1 may be decreased from bottom to top, and the widths of the second openings OP2 may be decreased from bottom to top. Since the spaces of the first openings OP1 are gradually decreased from bottom to top, the first support plate PLT1 advantageously prevents the introduction of contaminant particles that are likely to exist under the first support plate PLT1.

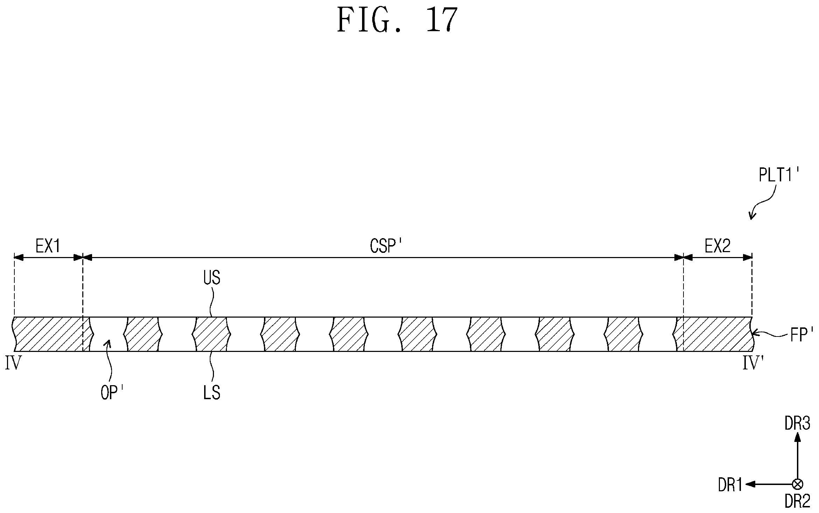

FIG. 17 is a view illustrating a first comparative support plate PLT1' according to a comparative example.

FIG. 17 illustrates a cross-section corresponding to FIG. 13, and hereinafter, components of the first comparative support plate PLT1' illustrated in FIG. 17 will be described focusing on components different from those of the first support plate PLT1 illustrated in FIG. 13.

Referring to FIG. 17, the first comparative support plate PLT1' may be disposed under the display module DM like the first comparative support plate PLT1 illustrated in FIG. 13. A plurality of openings OP' may be defined in a curved portion CSP' of a folding part FP' of the first comparative support plate PLT1'.

The openings OP' may be larger than the openings OP illustrated in FIG. 13. To improve flexibility, the openings OP' may be formed such that the openings OP' are larger than the openings OP illustrated in FIG. 13. For example, each of the openings OP' may have a width of about 110 micrometers (µm) in the first direction DR1. Although not illustrated, the openings OP' may be formed by performing an etching process on the upper surface US of the curved portion CSP' and the lower surface LS of the curved portion CSP'.

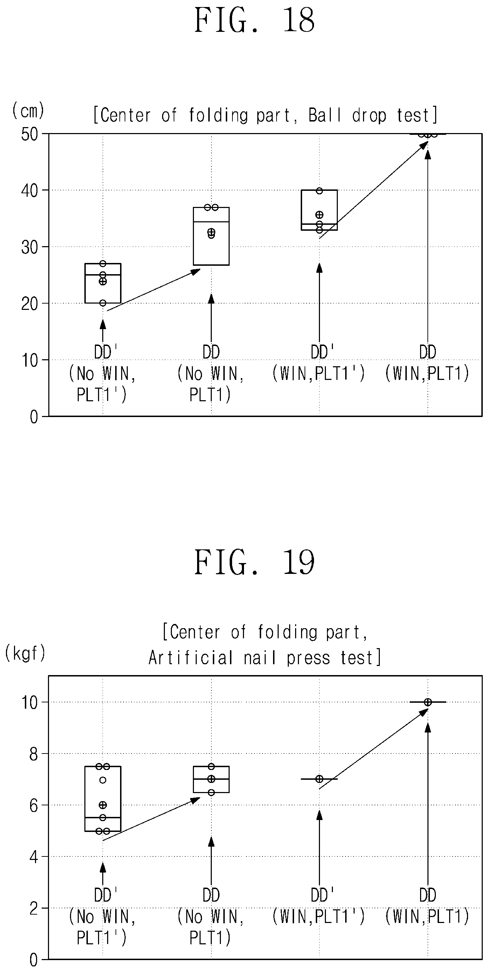

FIG. 18 is a view illustrating a ball drop test result for the display device of the present disclosure and a comparative display device including the first comparative support plate illustrated in FIG. 17. FIG. 19 is a view illustrating an artificial nail press test result for the display device of the present disclosure and the comparative display device including the first comparative support plate illustrated in FIG. 17.

In FIGS. 18 and 19, the number of tested display devices DD may be four, and the number of tested comparative display devices DD' may be four. The tests were performed on the central portion of the curved portion CSP of the first support plate PLT1 and the central portion of the curved portion CSP' of the first comparative support plate PLT1'.

In FIGS. 18 and 19, (No WIN, PLT1) represents the display devices DD that do not include a window WIN and a window protection layer WP, and (No WIN, PLT1') represents the comparative display devices DD' that do not include the window WIN and the window protection layer WP. In some aspects, in FIGS. 18 and 19, (WIN, PLT1) represents the display devices DD including the window WIN and the window protection layer WP, and (WIN, PLT1') represents the comparative display devices DD' including the window WIN and the window protection layer WP.

Referring to FIG. 18, the ball drop test may be performed by dropping a metal ball having a certain weight (e.g., 21.7 g) toward the display devices DD and the comparative display devices DD' from above the display devices DD and the comparative display devices DD'.

The ball drop test may be performed by gradually increasing the height of the ball by a certain height from the upper surfaces of the display devices DD and the comparative display devices DD'. The maximum height in the ball drop test was 50 centimeters (cm). The height of the ball was increased by 1 centimeter (cm), and the ball was dropped toward the display devices DD and the comparative display devices DD'.

The test values illustrated in FIG. 18 represent the numerical values at which the display devices DD and the comparative display devices DD' are not damaged when the ball is dropped with a gradual increase in its height. For example, if the display device DD is not damaged when the ball is dropped at a height of 30 centimeters (cm) and the display device DD is damaged when the ball is dropped at a height of 31 centimeters (cm), the ball drop test value of the corresponding display device DD may be 30 centimeters (cm). Damage to the display device DD may be determined based on whether a dark spot appears on the display module DM in an image display operation of the display module DM.

The test ranges illustrated in FIG. 18 represent the distribution area of the test result values of the display devices DD and the distribution area of the test result values of the comparative display devices DD'.

In the ball drop test, the test values of the comparative display devices DD' that do not include the window WIN and the window protection layer WP may range from about 20 centimeters (cm) to about 27 centimeters (cm).

In the ball drop test, the test values of the display devices DD that do not include the window WIN and the window protection layer WP may range from about 27 centimeters (cm) to about 37 centimeters (cm).

Accordingly, in the ball drop test, the impact resistance of the display devices DD that do not include the window WIN and the window protection layer WP may be greater than the impact resistance of the comparative display devices DD' that do not include the window WIN and the window protection layer WP.

In the ball drop test, the test values of the comparative display devices DD' including the window WIN and the window protection layer WP may range from about 33 centimeters (cm) to about 40 centimeters (cm).

In the ball drop test, the test values of the display devices DD including the window WIN and the window protection layer WP may be 50 centimeters (cm). That is, even though the ball was dropped toward the display devices DD including the window WIN and the window protection layer WP at a height of 50 centimeters (cm) that is the maximum height of the ball, the display devices DD including the window WIN and the window protection layer WP were not damaged.

Accordingly, in the ball drop test, the impact resistance of the display devices DD including the window WIN and the window protection layer WP may be greater than the impact resistance of the comparative display devices DD' including the window WIN and the window protection layer WP.

Referring to FIG. 19, the artificial nail press test may be performed by pressing an artificial nail toward the display devices DD and the comparative display devices DD' from above the display devices DD and the comparative display devices DD'.

The artificial nail press test may be performed by bringing the artificial nail into contact with the upper surfaces of the display devices DD and the comparative display devices DD' and gradually increasing the pressure of the artificial nail by a certain pressure. The maximum pressure in the artificial nail press test was 10 kilogram force (kgf). The pressure of the artificial nail was increased by 0.5 kilogram force (kgf), and the artificial nail was pressed toward the display devices DD and the comparative display devices DD'.

The test values illustrated in FIG. 19 represent the numerical values at which the display devices DD and the comparative display devices DD' are not damaged when the artificial nail is pressed against the display devices DD and the comparative display devices DD' with a gradual increase in its pressure. For example, if the display device DD is not damaged when the pressure of the artificial nail is 7 kilogram force (kgf) and the display device DD is damaged when the pressure of the artificial nail is 7.5 kilogram force (kgf), the artificial nail press test value of the corresponding display device DD may be 7 kilogram force (kgf).

The test ranges illustrated in FIG. 19 represent the distribution area of the test result values of the display devices DD and the distribution area of the test result values of the comparative display devices DD'.

In the artificial nail press test, the test values of the comparative display devices DD' that do not include the window WIN and the window protection layer WP may range from about 5 kilogram force (kgf) to about 7.5 kilogram force (kgf).

In the artificial nail press test, the test values of the display devices DD that do not include the window WIN and the window protection layer WP may range from about 6.5 kilogram force (kgf) to about 7.5 kilogram force (kgf).

In the artificial nail press test, based on a minimum value, the impact resistance of the display devices DD that do not include the window WIN and the window protection layer WP may be greater than the impact resistance of the comparative display devices DD' that do not include the window WIN and the window protection layer WP.

In the artificial nail press test, the test values of the comparative display devices DD' including the window WIN and the window protection layer WP may be 7 kilogram force (kgf).

In the artificial nail press test, the test values of the display devices DD including the window WIN and the window protection layer WP may be 10 kilogram force (kgf). That is, even though the artificial nail was pressed against the display devices DD including the window WIN and the window protection layer WP at a pressure of 10 kilogram force (kgf) that is the maximum pressure of the artificial nail, the display devices DD including the window WIN and the window protection layer WP were not damaged.

Accordingly, in the artificial nail press test, the impact resistance of the display devices DD including the window WIN and the window protection layer WP may be greater than the impact resistance of the comparative display devices DD' including the window WIN and the window protection layer WP.

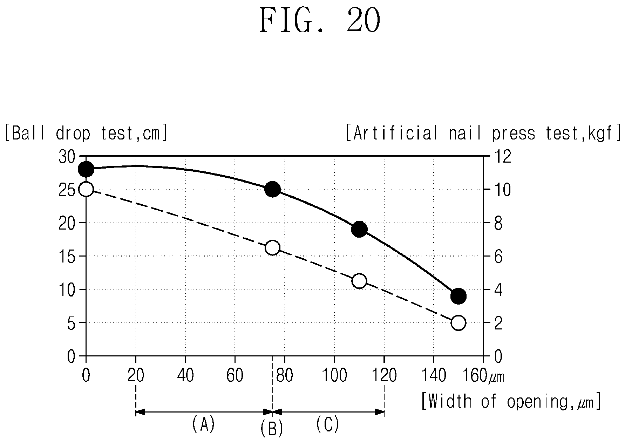

FIG. 20 is a graph depicting results of a ball drop test and an artificial nail press test performed on a comparative display device while varying the widths of the openings illustrated in FIG. 17.

Referring to FIG. 20, the ball drop test and the artificial nail press test were performed on the comparative display device DD' while varying the widths of the openings OP' of the curved portion CSP' from 0 micrometers (µm) to 160 micrometers (µm) in the comparative display device DD'. In an example case in which the widths of the openings OP' are equal to 0, the example case represents the first comparative support plate PLT1' in which openings are not defined.

As the widths of the openings OP' are increased, the test values in the ball drop test and the artificial nail press test may be gradually decreased. That is, as the widths of the openings OP' are increased, the impact resistance of the comparative display device DD' may be decreased.

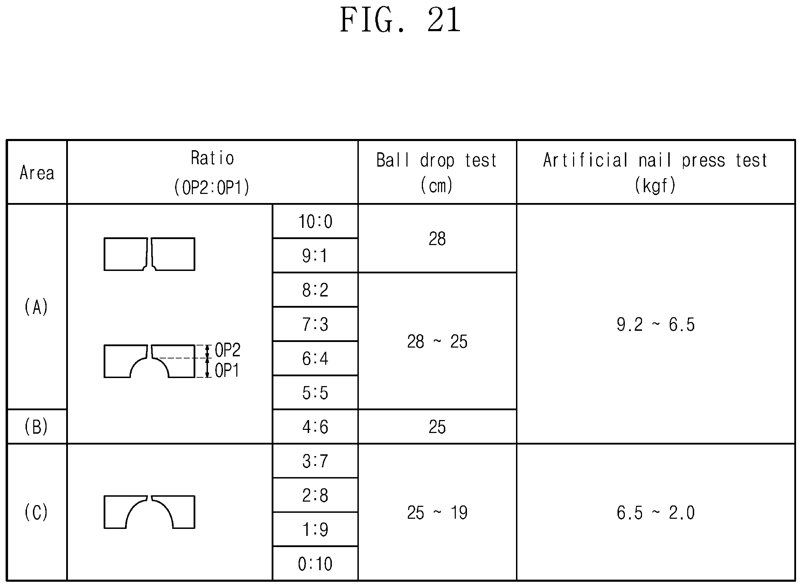

FIG. 21 is a table illustrating results of a ball drop test and an artificial nail press test performed on the display device while varying the ratio between the first openings and the second openings of the first support plate of the present disclosure.

The ratio illustrated in FIG. 21 represents the ratio between the second openings OP2 and the first openings OP1. The ratio between each of the second openings OP2 and each of the first openings OP1 may substantially represent the ratio between the second depth DTH2 and the first depth DTH1 illustrated in FIG. 14.

As the percentage of the first openings OP1 is decreased, the ball drop test value and the artificial nail press test value may be increased. That is, impact resistance may be improved. As the percentage of the first openings OP1 is increased, the ball drop test value and the artificial nail press test value may be decreased. That is, impact resistance may be decreased.

Range A, range B, and range C represent corresponding portions in the test result of FIG. 20 and the test result of FIG. 21. For example, based on range B, in FIG. 21, the ball drop test value may be 25 centimeters (cm) when the ratio between each of the second openings OP2 and each of the first openings OP1 is 4:6. Based on range B, in FIG. 20, the ball drop test value may be 25 centimeters (cm) when the openings OP' have a width of 75 micrometers (µm).

That is, the widths of the openings OP' corresponding to the ball drop test value of 25 centimeters (cm) may be 75 micrometers, and the ratio between each of the second openings OP2 and each of the first openings OP1 that corresponds to the ball drop test value of 25 centimeters (cm) may be 4:6.

Based on range B, in FIG. 21, the artificial nail press test value may be 6.5 kilogram force (kgf) when the ratio between each of the second openings OP2 and each of the first openings OP1 is 4:6. Based on range B, in FIG. 20, the artificial nail press test value may be 6.5 kilogram force (kgf) when the openings OP' have a width of 75 micrometers (µm).

That is, the widths of the openings OP' corresponding to the artificial nail press test value of 6.5 kilogram force (kgf) may be 75 micrometers, and the ratio between each of the second openings OP2 and each of the first openings OP1 that corresponds to the artificial nail press test value of 6.5 kilogram force (kgf) may be 4:6.

In an embodiment of the present disclosure, the ratio between each of the second openings OP2 and each of the first openings OP1 may be set to 4:6 such that the curved portion CSP has appropriate flexibility and impact resistance.

In an example in which the ratio between each of the second openings OP2 and each of the first openings OP1 ranges from 7:3 to 3:7, the ball drop test value may range from 25 centimeters (cm) to 28 centimeters (cm). In an example in which the ratio between each of the second openings OP2 and each of the first openings OP1 ranges from 7:3 to 3:7, the artificial nail press test value may range from 9.2 kilogram force (kgf) to 6.5 kilogram force (kgf).

In an example in which the ratio between the second thickness Tt and the first thickness Tb ranges from 7:3 to 3:7, the ball drop test value may range from 25 centimeters (cm) to 28 centimeters (cm), and the artificial nail press test value may range from 9.2 kilogram force (kgf) to 6.5 kilogram force (kgf).

In an example in which the ratio between the second thickness Tt and the first thickness Tb ranges from 7:3 to 3:7, the second thickness Tt may have a value in the range of 30% to 70% of the thickness T. In this case, the impact resistance performance of the display device DD for the ball drop test value and the artificial nail press test value may be improved.

In an example case in which the second thickness Tt is in the range of 80% to 100% of the thickness T, the impact resistance performance of the display device DD for the ball drop test value and the artificial nail press test value may be further improved. However, in this case, the depth of the second opening OP2 may increase, and therefore the amount of laser processing for forming the second opening OP2 may increase. In an example in which the amount of laser processing increases, the laser process time may increase. The laser process will be described herein with reference to FIG. 22C.

In an example case in which the second thickness Tt is in the range of 0% to 20% of the thickness T, the amount of laser processing may decrease, and thus the laser process time may decrease. However, since the size of the first opening OP1 increases, the impact resistance performance of the display device DD may be reduced.

In an embodiment of the present disclosure, the ratio between each of the second openings OP2 and each of the first openings OP1 may be diversely set depending on a selection by a manufacturer or designer. In an embodiment of the present disclosure, in consideration of the impact resistance performance of the display device DD for the ball drop test value and the artificial nail press test value, the second thickness Tt may have a value in the range of 30% to 70% of the thickness T.

FIGS. 22A to 22D are views illustrating the manufacturing method of the display device according to an embodiment of the present disclosure.

FIGS. 22A to 22D illustrate cross-sections corresponding to FIGS. 13 and 16.

In the descriptions of the method and processes herein, the operations may be performed in a different order than the order illustrated and/or described, or the operations may be performed in different orders or at different times. Certain operations may also be left out of the flowcharts, one or more operations may be repeated, or other operations may be added. Descriptions that an element "may be disposed," "may be formed," and the like include methods, processes, and techniques for disposing, forming, positioning, and modifying the element, and the like in accordance with example aspects described herein.

Referring to FIG. 22A, the method may include preparing the first support plate PLT1, a photoresist PR, and masks MSK. The photoresist PR may be disposed on the upper surface US and the lower surface LS of the first support plate PLT1. The masks MSK may be disposed on the upper surface and the lower surface of the photoresist PR.

The method may include defining a plurality of mask openings M-OP in the mask MSK disposed on the lower surface of the photoresist PR. Portions of the photoresist PR that overlap the openings M-OP may be exposed to light by the openings M-OP. Portions of the photoresist PR disposed on the lower surface of the first support plate PLT1 may be exposed to light. Accordingly, for example, the method may include developing and removing the exposed portions of the photoresist PR.

Referring to FIG. 22B, the method may include defining openings P-OP in the photoresist PR by removing the portions of the photoresist PR by a developing process. The openings P-OP may be defined in the photoresist PR disposed on the lower surface of the first support plate PLT1.

The method may include supplying an etching solution ETH to the lower surface LS of the folding part FP through the openings P-OP. Specifically, the method may include providing the etching solution ETH to the lower surface LS of the curved portion CSP with the photoresist PR as a mask.

Referring to FIGS. 22B and 22C, the method may include removing portions of the curved portion CSP exposed by the openings P-OP by the etching solution ETH. The portions of the curved portion CSP removed by the etching solution ETH are illustrated in gray in FIG. 22B. This process may be defined as an etching process.

The method may include defining the first openings OP1 in the lower surface LS of the folding part FP (specifically, the lower surface LS of the curved portion CSP) by the etching solution ETH. In an example viewed in the second direction DR2, the first openings OP1 may be defined to each have a shape that is convex upward. In an example in which the first openings OP1 are formed by the etching process, the first inner surfaces IS1 that define the first openings OP1 may each have a curved surface. The first openings OP1 defined by the etching solution ETH may correspond to the first openings OP1 illustrated in FIG. 13.

Referring to FIG. 22C, the method may include removing the photoresist PR, and further, applying a laser beam LB toward the first openings OP1 from below the curved portion CSP of the folding part FP. The laser beam LB may be a UV laser, and the power of the laser beam LB may range from 5W to 7W. The method may include applying the laser beam LB to areas of the curved portion CSP for defining the second openings OP2.

For example, with reference to FIG. 12, the laser beam LB may be applied to the areas for forming the second openings OP2, while moving the laser beam LB in the second direction DR2. For example, the laser beam LB may be applied to the curved portion CSP 25 times in one direction (e.g., the second direction DR2).

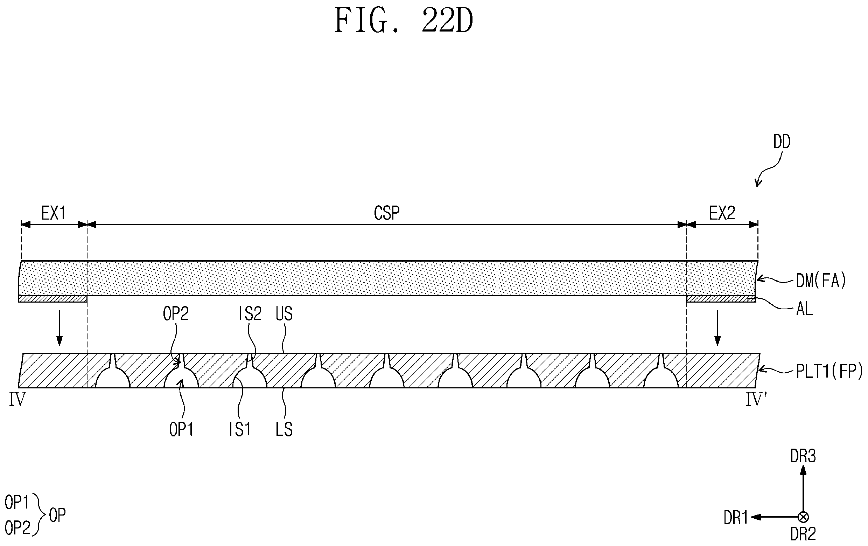

Referring to FIGS. 22C and 22D, the method may include defining the second openings OP2 penetrating the upper surface US of the folding part FP by applying the laser beam LB toward the first openings OP1. Specifically, the second openings OP2 as defined by the method may penetrate the upper surface of the curved portion CSP.

In an example in which the second openings OP2 are formed by the laser beam LB, the second inner surfaces IS2 that define the second openings OP2 may be inclined surfaces. The second openings OP2 defined by the laser beam LB may correspond to the second openings OP2 illustrated in FIG. 13.

The method may support increased consistency in applying the laser beam LB to a surface. The surface to which the laser beam LB is applied (e.g., the upper sides of the first inner surfaces IS1 that are concave upward in FIG. 22C) may be further heated and melted because the laser beam LB is more consistently applied to the surface. In this case, the protrusion PT illustrated in FIG. 14 may be formed such that the protrusion PT protrudes from each of the second inner surfaces IS2.

The protrusion PT may be formed by the laser beam LB used in the laser process. The protrusion PT may not be formed on the upper surface US of the curved portion CSP to which the laser beam LB is not applied.

The method may include performing the described process in association with achieving a target surface roughness of the first inner surface IS1 (e.g., by using the laser beam LB) and a target surface roughness of the second inner surface IS2 (e.g., by using the etching solution ETH). For example, depending on the described process, the surface roughness of the first inner surface IS1 formed by the laser beam LB may be greater than the surface roughness of the second inner surface IS2 formed by the etching solution ETH. The first support plate PLT1 may be manufactured based on at least the above-described process.

The method may include disposing the display module DM on the first support plate PLT1. The method may include attaching the display module DM to the upper surface US of the first support plate PLT1 by the adhesive layer AL.

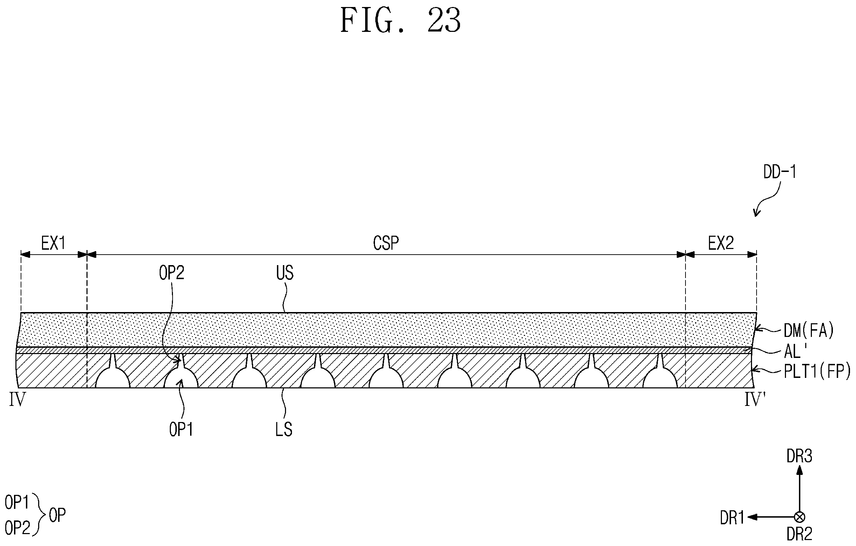

FIG. 23 is a view illustrating a configuration of a display device according to an embodiment of the present disclosure.

FIG. 23 illustrates a cross-section corresponding to FIG. 16, and hereinafter, the configuration of the display device DD-1 illustrated in FIG. 23 will be described focusing on components different from those of the display device DD illustrated in FIG. 16.

Referring to FIG. 23, an adhesive layer AL' of a display module DM may be disposed such that the adhesive layer AL' overlaps the entire folding part FP. For example, unlike the adhesive layer AL of the display module DM illustrated in FIG. 16, the adhesive layer AL' illustrated in FIG. 23 may be disposed such that the adhesive layer AL' overlaps a curved portion CSP.

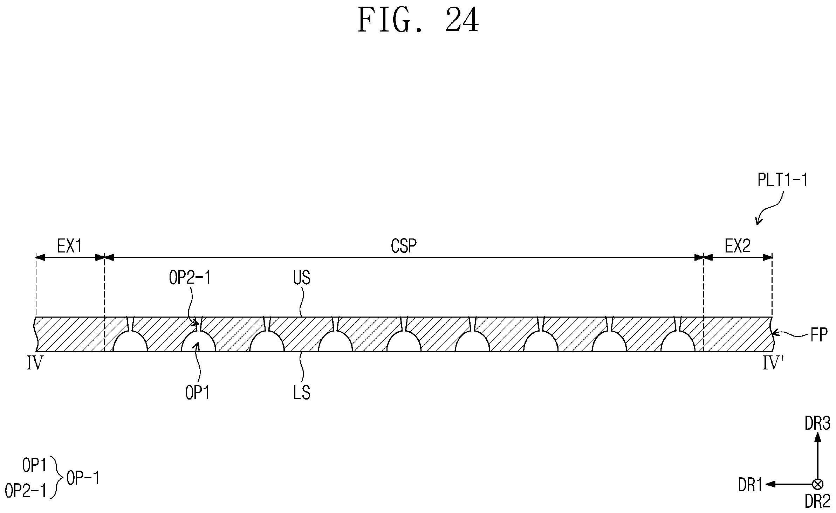

FIGS. 24 to 28 are views illustrating configurations of first support plates according to various embodiments of the present disclosure.

FIGS. 24 to 28 illustrate cross-sections corresponding to FIG. 13. Hereinafter, the configurations of the first support plates PLT1-1 to PLT1-5 illustrated in FIGS. 24 to 28 will be described focusing on components different from those of the first support plate PLT1 illustrated in FIG. 13.

Referring to FIG. 24, each of a plurality of openings OP-1 defined in the first support plate PLT1-1 may include a first opening OP1 and a second opening OP2-1. The first openings OP1 may be substantially the same as the first openings OP1 illustrated in FIG. 13. Accordingly, the width of each of the first openings OP1 in the first direction DR1 may be gradually decreased from bottom to top. The width of each of the second openings OP2-1 in the first direction DR1 may be gradually increased from bottom to top.

The first openings OP1 may be formed through the described etching process. That is, the first openings OP1 may be formed by providing the etching solution ETH toward the lower surface LS of the curved portion CSP through the openings P-OP of the photoresist PR as illustrated in FIG. 22B.

The second openings OP2-1 may be formed through the described laser process. However, unlike the second openings OP2 in FIG. 22C, the second openings OP2-1 may be formed by applying the laser beam LB toward the upper surface US of the curved portion CSP from above the folding part FP. In an example in which the laser beam LB is applied toward the upper surface US of the curved portion CSP from above the folding part FP, the second openings OP2-1 may be formed such that the width WT of each of the second openings OP2-1 is gradually increased from bottom to top.

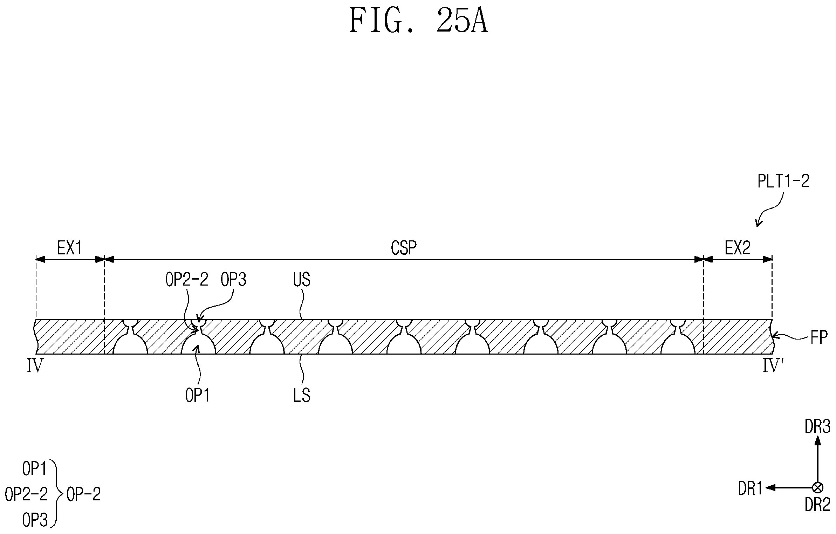

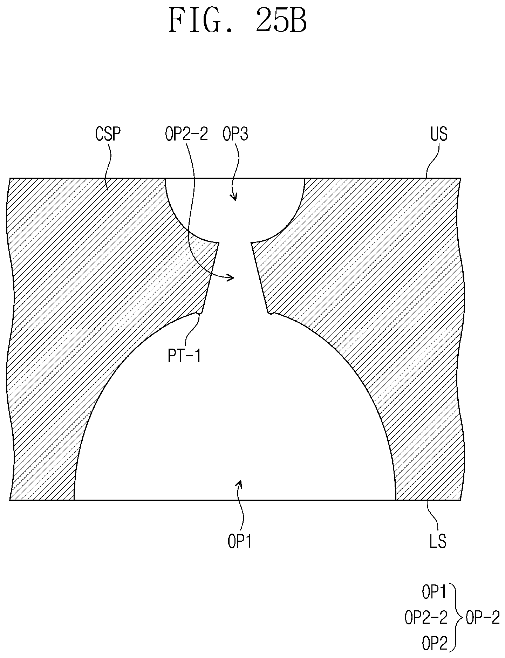

Referring to FIGS. 25A and 25B, each of a plurality of openings OP-2 defined in the first support plate PLT1-2 may include a first opening OP1, a second opening OP2-2, and a third opening OP3. FIG. 25B is an enlarged view of one of the openings OP-2 illustrated in FIG. 25A.

The first openings OP1 may be defined in the lower surface LS of the folding part FP, and the third openings OP3 may be defined in the upper surface US of the folding part FP. Specifically, the first openings OP1 may be defined in the lower surface LS of the curved portion CSP, and the third openings OP3 may be defined in the upper surface US of the curved portion CSP. The second opening OP2-2 may be defined between the first opening OP1 and the third opening OP3.

The width of each of the first openings OP1 in the first direction DR1 may gradually decrease in a direction from a bottom to a top of the display device DD, and the width of each of the third openings OP3 in the first direction DR1 may gradually decrease in a direction from the top to the bottom of the display device DD. The width of each of the second openings OP2-2 in the first direction DR1 may gradually decrease in a direction from the bottom to the top of the display device DD.

The first openings OP1 may be formed through the described etching process. In some aspects, the third openings OP3 may be formed through the described etching process. For example, the third openings OP3 may be formed by providing the etching solution ETH toward the upper surface US of the curved portion CSP through openings (not illustrated) of a photoresist disposed on the upper surface US of the curved portion CSP. The second openings OP2-2 may be formed by applying the laser beam LB toward the first openings OP1 from below the curved portion CSP as illustrated in FIG. 22C. Depending on the laser process, protrusions PT-1 may be formed at the boundary between the first opening OP1 and the second opening OP2-2.

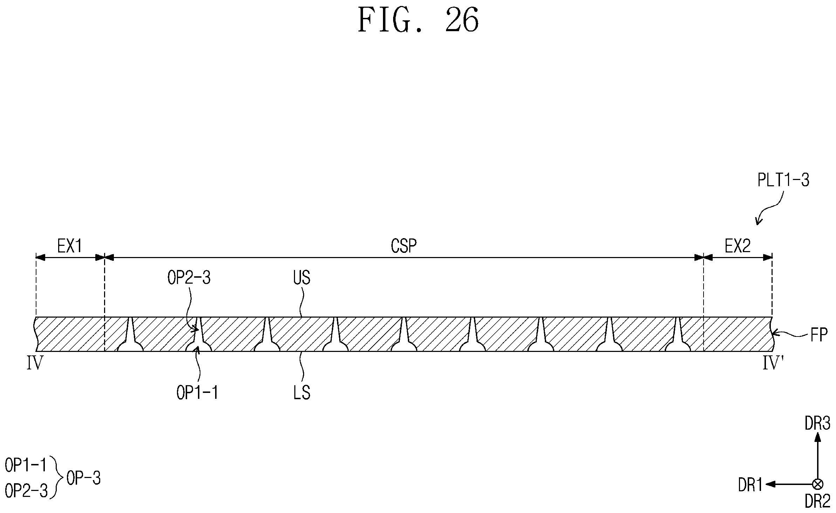

Referring to FIG. 26, each of a plurality of openings OP-3 defined in the first support plate PLT1-3 may include a first opening OP1-1 formed through an etching process and a second opening OP2-3 formed through a laser process. In the third direction, the depth of each of the first openings OP1-1 may be less than the depth of each of the second openings OP2-3. FIG. 14B described herein may be substantially an enlarged view of one of the openings OP illustrated in FIG. 26.

The ratio between the depth of each of the first openings OP1-1 and the depth of each of the second openings OP2-3 may be diversely set. For example, the ratio between the depth of each of the first openings OP1-1 and the depth of each of the second openings OP2-3 may be 3:7. However, without being limited thereto, as described herein with reference to FIG. 14B, the ratio between the depth of each of the first openings OP1-1 and the depth of each of the second openings OP2-3 may be 4:6.

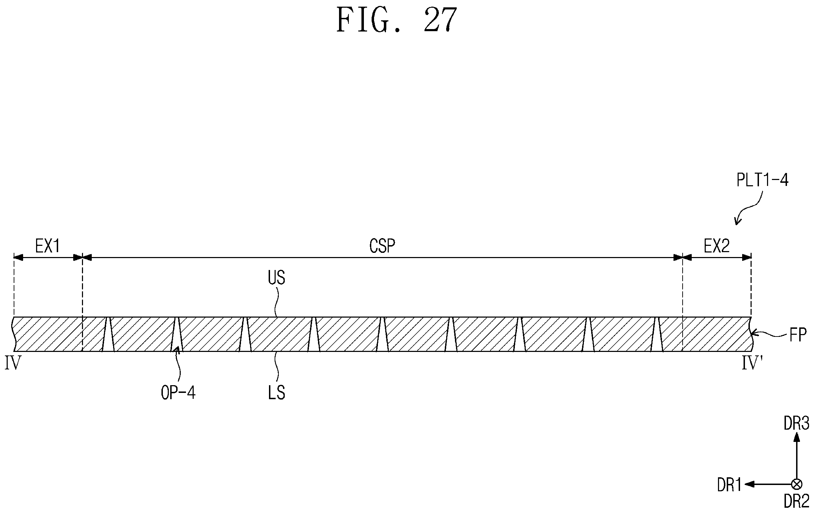

Referring to FIG. 27, a plurality of openings OP-4 may be defined in the first support plate PLT1-4. The openings OP-4 may be formed through a laser process. For example, the openings OP-4 may be formed by applying the described laser beam LB toward the lower surface LS of the curved portion CSP from below the folding part FP. The width of each of the openings OP-4 in the first direction DR1 may be gradually decreased from bottom to top.

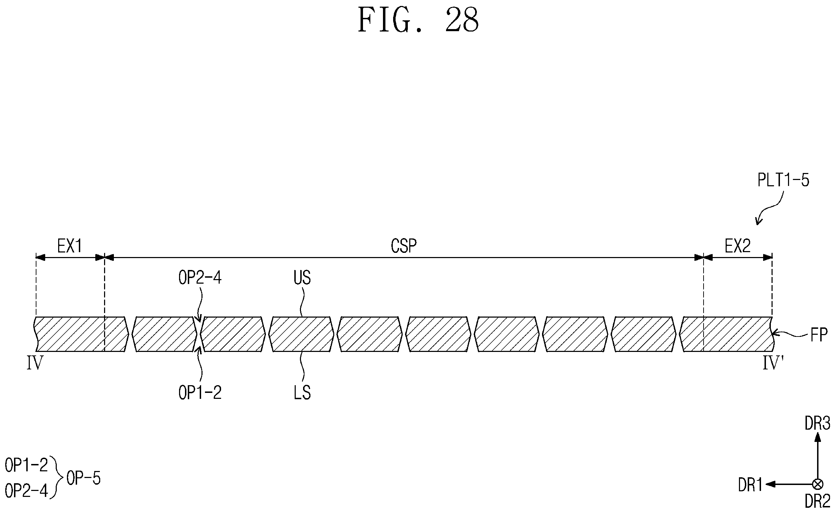

Referring to FIG. 28, each of a plurality of openings OP-5 defined in the first support plate PLT1-5 may include a first opening OP1-2 and a second opening OP2-4. The first opening OP1-2 may be defined in the lower surface LS of the curved portion CSP. The second opening OP2-4 may be defined in the upper surface US of the curved portion CSP.

The first opening OP1-2 may be formed by applying the laser beam LB toward the lower surface LS of the curved portion CSP from below the folding part FP. The second opening OP2-4 may be formed by applying the laser beam LB toward the upper surface US of the curved portion CSP from above the folding part FP.

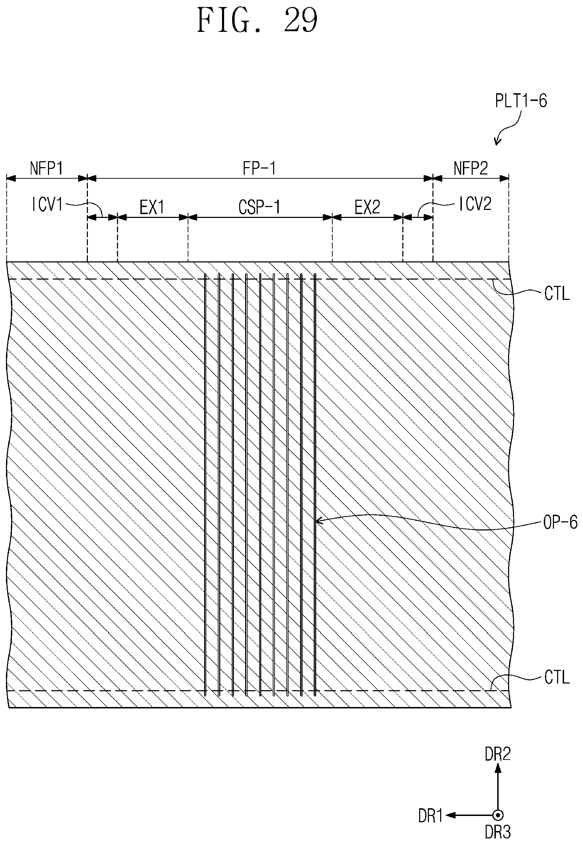

FIG. 29 is a view illustrating a configuration of a first support plate according to an embodiment of the present disclosure.

In FIG. 29, a plan view of a folding part FP-1 of the first support plate PLT1-6 is illustrated.

Referring to FIG. 29, a plurality of openings OP-6 may be defined in a curved portion CSP-1 of the folding part FP-1. The openings OP-6 may extend in the second direction DR2 and may be arranged in the first direction DR1. The openings OP-6 may be defined in a stripe pattern. The openings OP-6 may be formed through a laser process. For example, the openings OP-6 may have a cross-sectional shape corresponding to the first openings OP-4 illustrated in FIG. 27 or the second openings OP-5 illustrated in FIG. 28.

Cutting lines CTL may be defined on the first support plate PLT1-6. The cutting lines CTL may be adjacent to opposite sides of the first support plate PLT1-6 that are opposite to each other in the second direction DR2 and extend parallel to each other in the first direction DR1. The openings OP-6 may extend through the cutting lines CTL and be adjacent to the opposite sides of the first support plate PLT1-6.

Although not illustrated, the display module DM may be disposed inward of the cutting lines CTL and may be disposed such that the display module DM overlaps the openings OP-6. After the display module DM is attached to the first support plate PLT1-6, the first support plate PLT1-6 may be cut along the cutting lines CTL. In this case, the portions cut along the cutting lines CTL may be defined as new opposite sides of the first support plate PLT 1-6.

After the cutting process, the openings OP-6 may be open toward sides (opposite sides) of the folding part FP-1 that are defined as portions cut along the cutting lines CTL and that are opposite to each other in the second direction DR2.

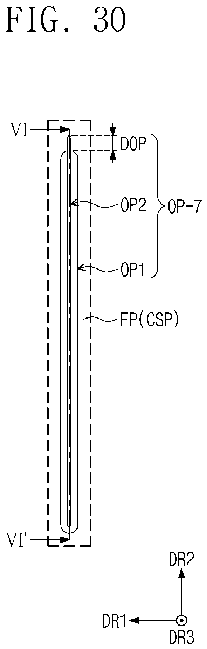

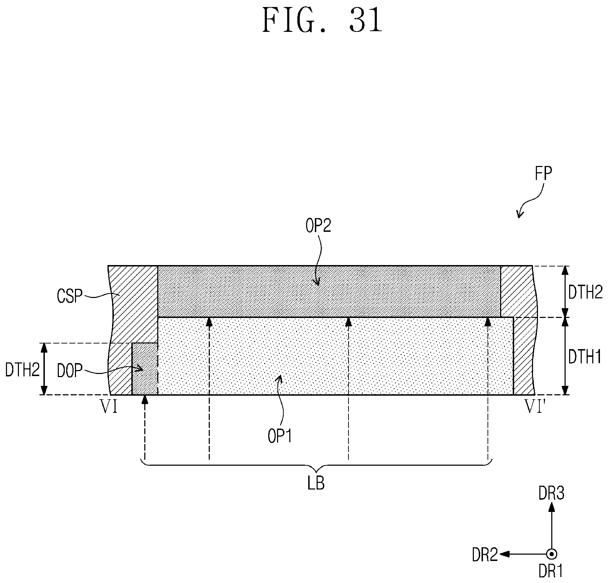

FIG. 30 is a view illustrating a configuration of an opening according to an embodiment of the present disclosure. FIG. 31 is a sectional view taken along line VI-VI' illustrated in FIG. 30.

In FIG. 30, one opening OP-7 is illustrated.

Referring to FIG. 30, the opening OP-7 may include a first opening OP1, a second opening OP2, and a dummy opening DOP. The first opening OP1 and the second opening OP2 may extend in the second direction DR2.

The dummy opening DOP may extend from one side of the first opening OP1 in the second direction DR2. The dummy opening DOP may extend from the one side of the first opening OP1 to the outside of the first opening OP1. The widths of the second opening OP2 and the dummy opening DOP in the first direction DR1 may be less than the width of the first opening OP1 in the first direction DR1.

Referring to FIG. 31, the dummy opening DOP may be defined in the lower surface LS of the folding part FP. Specifically, the dummy opening DOP may be defined in the lower surface LS of the curved portion CSP. The dummy opening DOP may extend from the first opening OP1 in the second direction DR2. The dummy opening DOP may not overlap the second opening OP2 when viewed from above the plane.

The dummy opening DOP may be formed through a laser process. In an example in which the second opening OP2 is formed by the laser beam LB, the laser beam LB may deviate from the first opening OP1 and may be provided outside the one side of the first opening OP1. In this case, the dummy opening DOP extending from the one side of the first opening OP1 may be formed by the laser beam LB.

Since the dummy opening DOP is formed by the laser beam LB for forming the second opening OP2, the dummy opening DOP may have substantially the same depth DTH2 as the second opening OP2.

The opening OP-7 illustrated in FIGS. 30 and 31 may be defined at a plurality of locations in the curved portion CSP.

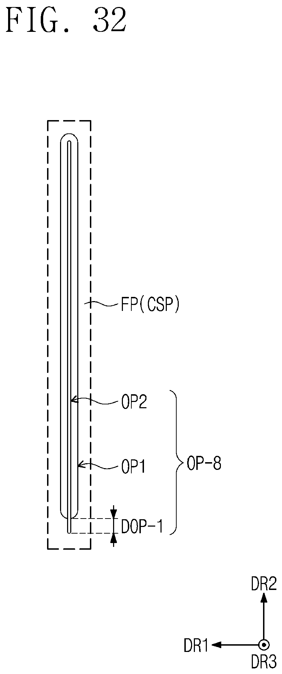

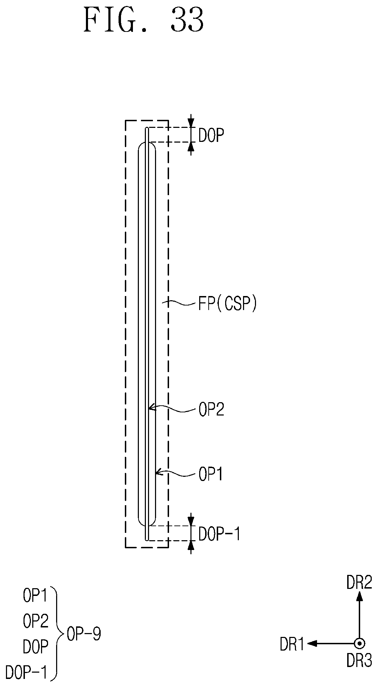

FIGS. 32 and 33 are views illustrating configurations of openings according to embodiments of the present disclosure.

FIGS. 32 and 33 illustrate plan views corresponding to FIG. 30, and one opening OP-8 and one opening OP-9 are illustrated in FIGS. 32 and 33, respectively.

Referring to FIG. 32, the opening OP-8 may include a first opening OP1, a second opening OP2, and a dummy opening DOP-1. The dummy opening DOP-1 may extend from an opposite side of the first opening OP1 in the second direction DR2. The dummy opening DOP-1 may extend from the opposite side of the first opening OP1 to the outside of the first opening OP1. The dummy opening DOP-1 may be substantially the same as the dummy opening DOP illustrated in FIG. 30, but differing with respect to the position.

Referring to FIG. 33, the opening OP-9 may include a first opening OP1, a second opening OP2, and dummy openings DOP and DOP-1. The dummy opening DOP may extend from one side of the first opening OP1 in the second direction DR2. The dummy opening DOP-1 may extend from an opposite side of the first opening OP1 in the second direction DR2.

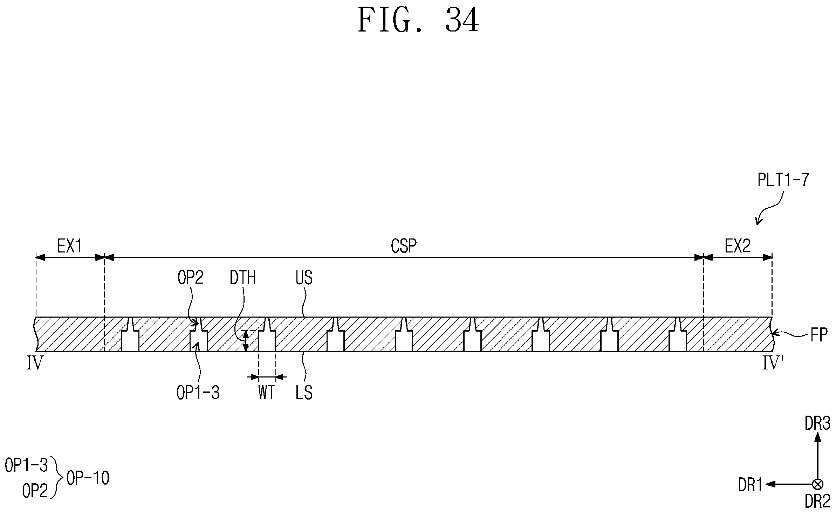

FIG. 34 is a view illustrating a configuration of a first support plate according to an embodiment of the present disclosure.

FIG. 34 illustrates a cross-section corresponding to FIG. 13. Hereinafter, the configuration of the first support plate PLT1-7 illustrated in FIG. 34 will be described focusing on components different from those of the first support plate PLT1 illustrated in FIG. 13.

Referring to FIG. 34, each of a plurality of openings OP-10 defined in the first support plate PLT1-7 may include a first opening OP1-3 and a second opening OP2. The width WT of each of the first openings OP1-3 in the first direction DR1 may be constant in the third direction DR3. The width WT of each of the first openings OP1-3 may be less than the depth DTH of each of the first openings OP1-3 in the third direction DR3.

In FIG. 14, the maximum width MWT1 of each of the first openings OP1 may be greater than the first depth DTH1 of each of the first openings OP1, and the etching process that forms the first openings OP1 may be defined as an isotropic etching process.

To form the first openings OP1-3 such that the width WT of each of the first openings OP1-3 is less than the depth DTH of each of the first openings OP1-3 as illustrated in FIG. 34, an anisotropic etching process may be used. The anisotropic etching process may be a dry etching process. The width WT of each of the first openings OP1-3 may be less than the maximum width MWT1 of each of the first openings OP1 illustrated in FIG. 14.

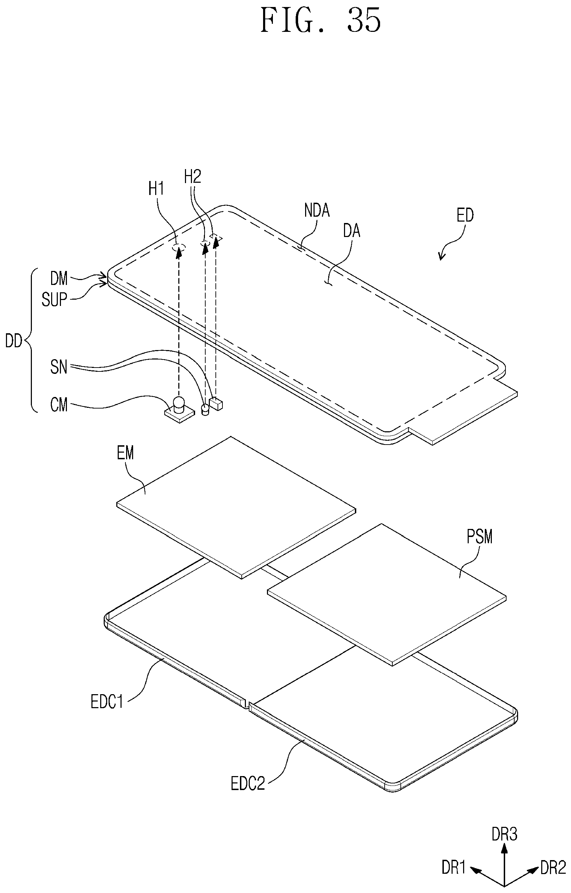

FIG. 35 is an exploded perspective view of an electronic device including the display module and the support part according to an embodiment of the present disclosure.

Referring to FIG. 35, the electronic device ED may include the display device DD, an electronic module EM, a power supply module PSM, and a case EDC1 and EDC2. Although not separately illustrated, the electronic device ED may further include a hinge structure for controlling a folding operation of the display device DD.

As described herein, the first hole H1 and the second holes H2 may be defined in the display device DD, the camera CM may be disposed in the first hole H1, and the sensors SN may be disposed in the second holes H2.

The electronic module EM and the power supply module PSM may be disposed under the support part SUP. Although not illustrated, the electronic module EM and the power supply module PSM may be connected with each other through a flexible circuit board. The electronic module EM may control an operation of the display module DM. The power supply module PSM may supply power to the display module DM.

The electronic module EM may include a processor. The processor may include at least one of a central processing unit (CPU), an application processor (AP), a graphic processing unit (GPU), a communication processor (CP), an image signal processor (ISP), and a controller.

The case EDC1 and EDC2 may accommodate the display module DM, the support part SUP, the camera CM, the sensors SN, the electronic module EM, and the power supply module PSM. To fold the display device DD, the case EDC1 and EDC2 may be divided into the first case EDC1 and the second case EDC2. The case EDC1 and EDC2 may protect the display module DM, the support part SUP, the camera CM, the sensors SN, the electronic module EM, and the power supply module PSM.

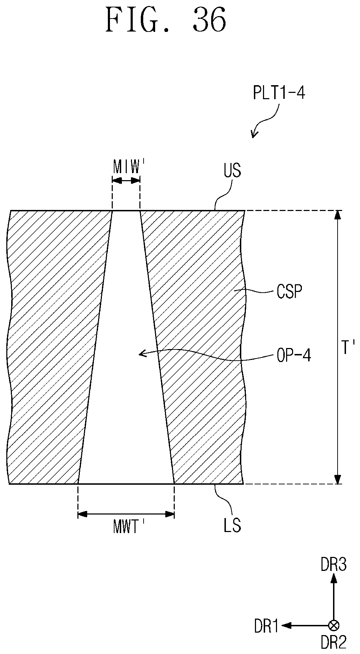

FIG. 36 is an enlarged view of one of the openings illustrated in FIG. 27.

Referring to FIG. 36, the thickness T' of the first support plate PLT1-4 may be greater than 0 micrometers (µm) and less than or equal to 170 micrometers (µm). The first support plate PLT1-4 may include carbon fiber reinforced plastic as a non-metal. The first support plate PLT1-4 including the non-metal may be lighter than the first support plate PLT1 described herein and may have a greater thickness than the first support plate PLT1. Accordingly, the first support plate PLT1-4 may have a thickness less than or equal to 170 micrometers (µm).

The minimum width MIW' of the opening OP-4 may be greater than 0 micrometers (µm) and less than or equal to 50 micrometers (µm). The minimum width MIW' may be defined as a portion of the opening OP-4 defined in the upper surface US. The maximum width MWT' of the opening OP-4 may be greater than 0 micrometers (µm) and less than or equal to 70 micrometers (µm). The maximum width MWT' may be defined as a portion of the opening OP-4 defined in the lower surface LS. The maximum width MWT' may be larger than the minimum width MIW'. For example, the difference between the maximum width MWT' and the minimum width MIW' may be greater than 0 micrometers (µm) and less than or equal to 20 micrometers (µm).

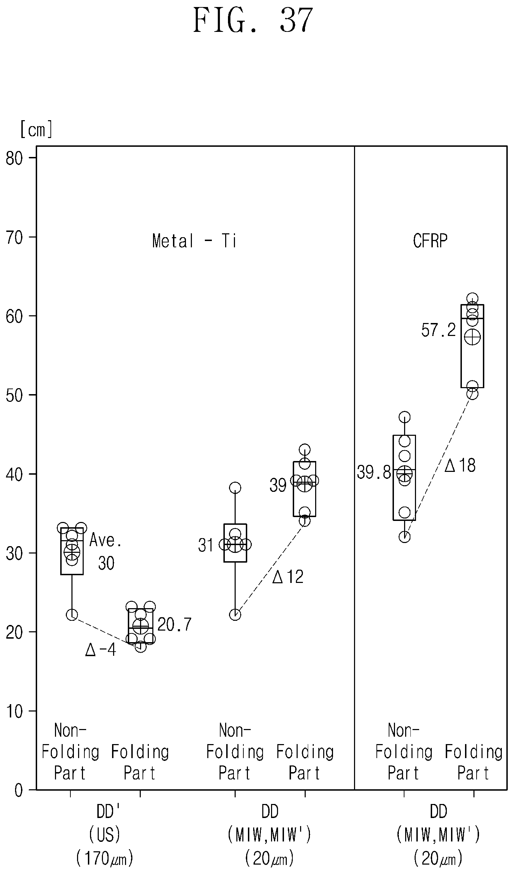

FIG. 37 is a view illustrating a ball drop test result for display devices including the support plates illustrated in FIGS. 13 and 27 and comparative display devices including the first comparative support plate illustrated in FIG. 17.

Referring to FIG. 37, the tests were performed on the plurality of comparative display devices DD' and the plurality of display devices DD, and the circled portions in the graph are numerical value portions of experimental results associated with the comparative display devices DD' and the display devices DD. The box portions may represent the portions where the test results are gathered. The numerical values adjacent to the box portions represent the averages Ave of the test results. The delta (Δ) values indicate increases or decreases of the test values. The folding part and the non-folding portion represent the folding part FP, the first non-folding part NFP1, and the second non-folding part NFP2 described herein.

The tests were performed on the first comparative support plate PLT1' including titanium metal Metal-Ti, the first support plates PLT1 and PLT1-4 including titanium metal Metal-Ti, and the first support plates PLT1 and PLT1-4 including carbon fiber reinforced plastic (CFRP).

The width of the opening OP' defined in the upper surface US of the first support plate PLT1 in the comparative display device DD' may be 170 micrometers (µm). The minimum widths MIW and MIW' of the openings OP and OP-4 defined in the upper surfaces US of the first support plates PLT1 and PLT1-4 may be 20 micrometers (µm).

In the comparative display device DD', the impact resistance of the folding part may be less than the impact resistance of the non-folding part. In the display device DD including titanium metal Metal-Ti, the impact resistance of the folding part may be greater than the impact resistance of the non-folding part. In the display device DD including carbon fiber reinforced plastic (CFRP), the impact resistance of the folding part may be greater than the impact resistance of the non-folding part.

The impact resistance of the folding part of the display device DD including titanium metal Metal-Ti may be greater than the impact resistance of the folding part of the comparative display device DD'. The impact resistance of the folding part of the display device DD including carbon fiber reinforced plastic (CFRP) may be greater than the impact resistance of the folding part of the display device DD including titanium metal Metal-Ti.

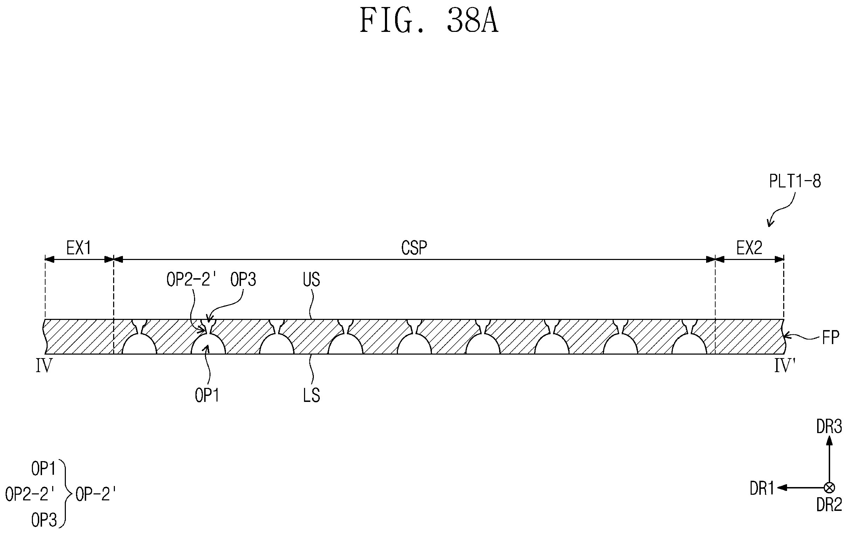

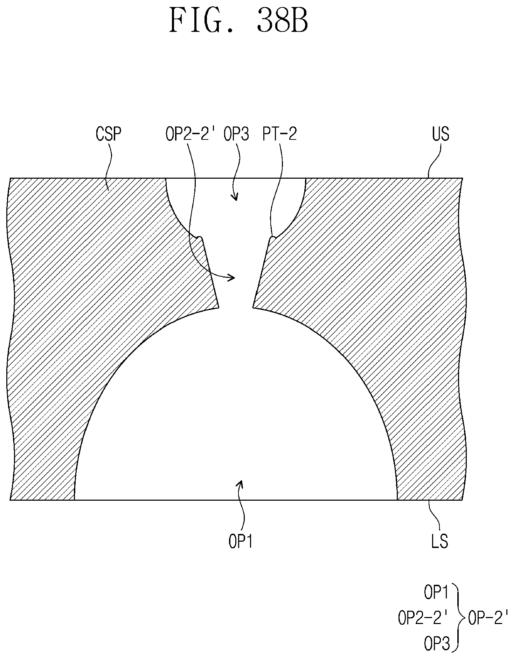

FIG. 38A is a view illustrating a configuration of a first support plate according to an embodiment of the present disclosure. FIG. 38B is an enlarged view of one of openings OP-2' illustrated in FIG. 38A.

Hereinafter, the configuration of the first support plate PLT1-8 illustrated in FIGS. 38A and 38B will be described focusing on components different from those of the first support plate PLT1-2 illustrated in FIG. 25A.

Referring to FIGS. 38A and 38B, the width of a second opening OP2-2' of each of the openings OP-2' may be gradually increased from bottom to top. The second opening OP2-2' may be formed by applying the laser beam LB described herein toward a third opening OP3 from above the upper surface US of a curved portion CSP. Depending on the laser process, protrusions PT-2 may be formed at the boundary between the third opening OP3 and the second opening OP2-2'.

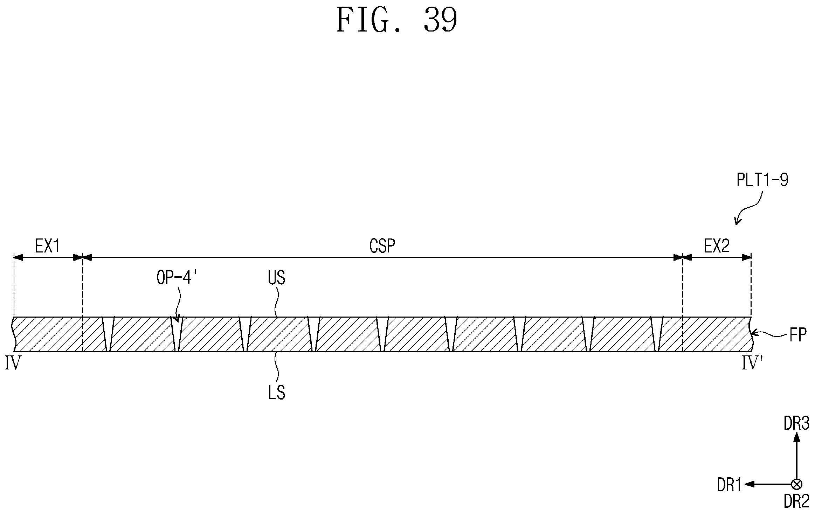

FIG. 39 is a view illustrating a configuration of a first support plate PLT1-9 according to an embodiment of the present disclosure.

Hereinafter, the configuration of the first support plate PLT1-9 illustrated in FIG. 39 will be described focusing on components different from those of the first support plate PLT1-4 illustrated in FIG. 27.

Referring to FIG. 39, the widths of openings OP-4' defined in the first support plate PLT1-9 may be gradually decreased from top to bottom. The openings OP-4' may be formed by applying the laser beam LB described herein toward a curved portion CSP from above the upper surface LS of the curved portion CSP.

According to the embodiments of the present disclosure, the first openings may be defined in the lower surface of the curved portion of the folding part of the support plate supporting the display module, and the second openings having a smaller width than the first openings may be defined in the upper surface of the curved portion. The flexibility of the curved portion may be increased by the first openings having a greater width than the second openings, and the support force of the curved portion may be improved by the second openings having a smaller width than the first openings.

Accordingly, when external impact is applied from above the display module toward the folding area of the display module that overlaps the curved portion, deformation of the folding area may be prevented by the curved portion with improved support force. Thus, the impact resistance of the display device may be improved.

While the present disclosure has been described with reference to embodiments thereof, it will be apparent to those of ordinary skill in the art that various changes and modifications may be made thereto without departing from the scope of the present disclosure as set forth in the following claims.

## Claims

1. A display device (DD) comprising:
a display module (DM) comprising a non-folding area (NFA1) and a folding area (FA) arranged in a first direction (DR1); and
a support plate (PLT) comprising a folding part (FP) overlapping the folding area (FA),
wherein an opening (OP) extending in a second direction crossing the first direction (DR1) is defined in the folding part (FP),
wherein the opening (OP) comprises:
a first opening (OP1) defined in a lower surface of the folding part (FP); and
a second opening (OP2) defined above the first opening (OP1), and
wherein in the second direction (DR2), a first length (LT1) of the first opening (OP1) and a second length of the second opening (OP2) are different from each other.

2. The display device (DD) of claim 1, wherein the second length (LT2) is less than the first length (LT1). and/or wherein
the second opening (OP2) is defined in an upper surface of the folding part (FP) and disposed in the first opening such that second opening (OP2) overlaps the first opening (OP1) in a plan view, and
the first opening (OP1) and the second opening (OP2) are defined such that the first opening (OP1) and the second opening (OP2) are continuous with each other.

3. The display device (DD) of claim 1 or 2, wherein:
a first width (WT1) of the first opening (OP1) in the first direction (DR1) gradually decreases in a direction from a bottom to a top of the display device (DD), and
a second width (WT2) of the second opening (OP2) in the first direction (DR1) gradually decreases in the direction from the bottom to the top of the display device (DD) and/or wherein the first width (WT1) is greater than the second width (WT2). and/or wherein:
a reduction rate of the first width (WT1) is varied, and
a reduction rate of the second width (WT2) is constant.

4. The display device (DD) of claims 1 to 3, wherein in a direction perpendicular to a plane defined by the first direction (DR1) and the second direction (DR2), a first depth (DTH1) of the first opening (OP1) is greater than a second depth (DTH2) of the second opening (OP2).

5. The display device (DD) of claim 4, wherein a ratio between the first depth (DTH1) and the second depth (DTH2) is 6:4 and/or wherein:
a maximum width of a first width (WT1) of the first opening (OP1) in the first direction (DR1) is greater than the first depth, and
a maximum width of a second width (WT2) of the second opening (OP2) in the first direction (DR1) is less than the second depth.

6. The display device (DD) of claims 1 to 5, wherein the folding part (FP) comprises:
a first inner surface defining the first opening (OP1) and having a curved shape; and
a second inner surface defining the second opening (OP2), wherein the second inner surface is an inclined surface having a straight-line shape.

7. The display device (DD) of claim 6, wherein a surface roughness of the first inner surface is different from a surface roughness of the second inner surface and/or wherein the folding part (FP) further comprises a protrusion adjacent to a boundary between the first inner surface and the second inner surface and protruding downward from the first inner surface and/or wherein when viewed in the second direction:
the first opening has a shape which is convex upward, and
the second opening has a trapezoidal shape.

8. The display device (DD) of claims 1 to 7, wherein:
the first opening (OP1) is formed by processing a portion of the folding part (FP) using an etching solution, and
the second opening (OP2) is formed by processing another portion of the folding part (FP) using a laser beam.

9. The display device (DD) of claims 1 to 8, wherein:
the display module (DM) comprises an adhesive layer attached to the support plate (PLT), and
the adhesive layer is disposed such that the adhesive layer overlaps the folding part (FP).

10. The display device (DD) of claims 1 to 9, wherein:
the opening (OP) further comprises a third opening (OP3) defined in an upper surface of the folding part (FP), and the second opening (OP2) is defined between the first opening (OP1) and the third opening (OP2), and
a width of the third opening (OP3) in the first direction (DR1) gradually decreases in a direction from a top to a bottom of the display device (DD).

11. The display device (DD) of claims 1 to 10, wherein in a direction perpendicular to a plane defined by the first direction (DR1) and the second direction (DR2), a first depth (DTH1) of the first opening (OP1) is less than a second depth (DTH2) of the second opening (OP2), wherein preferably a ratio between the first depth (DTH1) and the second depth (DTH2) is 4:6.

12. The display device (DD) of claims 1 to 11, wherein:
in a direction perpendicular to a plane defined by the first direction (DR1) and the second direction (DR2), a thickness of a portion of the folding part (FP) in which the first opening (OP1) is defined is defined as a first thickness (Tb), and a thickness of a portion of the folding part (FP) in which the second opening (OP2) is defined is defined as a second thickness (Tt), and
a ratio between the second thickness (Tt) and the first thickness (Tb) ranges from 7:3 to 3:7 and/or wherein the opening (OP) is open toward sides of the folding part (FP) which are opposite to each other in the second direction (DR2).

13. The display device (DD) of claims 1 to 12, wherein:
a dummy opening (DOP) extending from the first opening (OP1) in the second direction (DR2) and having a smaller width than the first opening (OP1) in the first direction (DR1) is further defined in the lower surface of the folding part (FP),
the dummy opening (DOP) does not overlap the second opening and/or wherein a maximum width of the first opening (OP1) in the first direction (DR1) is less than a depth of the first opening (OP1) in a direction perpendicular to a plane defined by the first direction (DR1) and the second direction (DR2).

14. The display device of claim 1, wherein:
a width of the first opening in the first direction gradually decreases in a direction from a bottom to a top of the display device, and
a width of the second opening in the first direction gradually increases in the direction from the bottom to the top of the display device.

15. A display (DD) device comprising:
a display module (DM) comprising a non-folding area (NFA1) and a folding area (FA) arranged in a first direction (DR1); and
a support plate (PLT) comprising a folding part (FP) overlapping the folding area (FA),
wherein an opening (OP) extending in a second direction (DR2) crossing the first direction (DR1) is defined in the folding part (FP),
wherein the opening (OP) comprises:
a first opening (OP1) defined in a lower surface of the folding part (FP); and
a second opening (OP2) defined in an upper surface of the folding part (FP),
wherein in the second direction (DR2), a first length (LT1) of the first opening (OP1) and a second length (LT2) of the second opening (OP2) are different from each other, and
wherein in a direction perpendicular to a plane defined by the first direction (DR1) and the second direction (DR2), a first depth (DTH1) of the first opening (OP1) and a second depth (DTH2) of the second opening (OP2) are different from each other.

16. The display device (DD) of claim 15, wherein:
the second length (LT2) is less than the first length (LT1), and
the first depth (DTH1) is greater than the second depth (DTH2) and/or wherein the first depth (DTH1) is smaller than the second depth (DTH2).

17. A display device (DD) comprising:
a display module (DM) comprising a non-folding area (NFA1) and a folding area (FA) arranged in a first direction (DR1); and
a support plate (PLT) comprising a folding part (FP) overlapping the folding area (FA),
wherein an opening (OP) extending in a second direction crossing the first direction (DR1) is defined in the folding part (FP),
wherein the opening (OP) comprises:
a first opening (OP1) defined in a lower surface of the folding part (FP); and
a second opening (OP2) defined in an upper surface of the folding part (FP), and
wherein a first width (WT1) of the first opening (OP1) in the first direction (DR1) is greater than a second width (WT2) of the second opening (OP2) in the first direction (DR1), each of the first width (WT1) and the second width (WT2) gradually decreases in a direction from a bottom to a top of the display device (DD), a reduction rate of the first width (WT1) is varied, and a reduction rate of the second width (WT2) is constant.

18. An electronic device comprising:
a display device (DD) comprising a display module; and
an electronic module configured to control operation of the display module (DM),
wherein the display device (DD) comprises:
the display module (DM) comprising a non-folding area (NFA1) and a folding area (FA) arranged in a first direction (DR1); and
a support plate (PLT) comprising a folding part (FP) overlapping the folding area (FA),
wherein an opening (OP) extending in a second direction (DR2) crossing the first direction (DR1) is defined in the folding part (FP), and
wherein the opening (OP) comprises:
a first opening (OP1) defined in a lower surface of the folding part (FP); and
a second opening (OP2) defined above the first opening (OP1),
wherein in the second direction (DR2), a first length (LT1) of the first opening (OP1) and a second length (LT2) of the second opening (OP2) are different from each other.

19. The electronic device of claim 18, wherein in a direction perpendicular to a plane defined by the first direction (DR1) and the second direction (DR2), a first depth (DTH1) of the first opening (OP1) is smaller than a second depth (DTH2) of the second opening (OP2) and/or wherein:
in a direction perpendicular to a plane defined by the first direction (DR1) and the second direction (DR2), a thickness of a portion of the folding part (FP) in which the first opening (OP1) is defined is defined as a first thickness (Tb), and a thickness of a portion of the folding part (FP) in which the second opening (OP2) is defined is defined as a second thickness (Tt), and
a ratio between the second thickness (Tt) and the first thickness (Tb) ranges from 7:3 to 3:7, wherein preferably a ratio between the first depth (DTH1) and the second depth (DTH2) is 4:6.

20. A support plate (PLT) comprising:
a folding part (FP); and
a non-folding part (NFP) adjacent to the folding part (FP),
wherein an opening (OP) extending in a second direction crossing a first direction (DR1) is defined in the folding part (FP), and
wherein the opening (OP) comprises:
a first opening (OP1) defined in a lower surface of the folding part (FP); and
a second opening (OP2) defined above the first opening (OP1),
wherein in the second direction (DR2), a first length (LT1) of the first opening (OP1) and a second length (LT2) of the second opening (OP2) are different from each other.

21. The support plate (PLT) of claim 20, wherein in a direction perpendicular to a plane defined by the first direction (DR1) and the second direction (DR2), a first depth (DTH1) of the first opening (OP1) is smaller than a second depth (DTH2) of the second opening (OP2) and/or wherein: in a direction perpendicular to a plane defined by the first direction (DR1) and the second direction (DR2), a thickness of a portion of the folding part (FP) in which the first opening (OP1) is defined is defined as a first thickness (Tb), and a thickness of a portion of the folding part (FP) in which the second opening (OP2) is defined is defined as a second thickness (Tt), and
a ratio between the second thickness (Tt) and the first thickness (Tb) ranges from 7:3 to 3:7, wherein preferably a ratio between the first depth (DTH1) and the second depth (DTH2) is 4:6.

22. A method for manufacturing a support plate (PLT), the method comprising:
a step of preparing a support plate (PLT) and a photoresist disposed on a lower surface of the support plate (PLT) and having an opening defined therein to overlap a folding part (FP) of the support plate (PLT);
a step of defining a first opening in a lower surface of the folding part (FP) by supplying an etching solution (ETH) to the lower surface of the folding part (FP) through the opening of the photoresist; and
a step of defining a second opening (OP2) penetrating an upper surface of the folding part (FP), by applying a laser beam toward the first opening from below the folding part (FP);
wherein in a second direction crossing a first direction (DR1), a first length (LT1) of the first opening (OP1) and a second length (LT2) of the second opening (OP2) are different from each other, and
wherein in a direction perpendicular to a plane defined by a first direction (DR1) and the second direction (DR2), a first depth (DTH1) of the first opening (OP1) and a second depth (DTH2) of the second opening (OP2) are different from each other.

23. The method of claim 22, wherein in the direction perpendicular to the plane defined by the first direction (DR1) and the second direction, the first depth (DTH1) of the first opening (OP1) is smaller than the second depth (DTH2) of the second opening (OP2), and/or wherein: in the direction perpendicular to the plane defined by the first direction (DR1) and the second direction (DR2), a thickness of a portion of the folding part (FP) in which the first opening (OP1) is defined is defined as a first thickness (Tb), and a thickness of a portion of the folding part (FP) in which the second opening (OP2) is defined is defined as a second thickness (Tt), and
a ratio between the second thickness (Tt) and the first thickness (Tb) ranges from 7:3 to 3:7, wherein preferably a ratio between the first depth (DTH1) and the second depth (DTH2) is 4:6.
